# EUROPEAN PATENT APPLICATION

(11) **EP 1 107 288 A2**
(43) Date of publication of application: **13.06.2001**
(21) Application number: 00125441.6
(22) Date of filing: 20.11.2000
(51) Int. Cl.: H01L 21/00

(54) **Substrate processing system and method**

(30) Priority: 30.11.1999 US 451628
(71) Applicant: Applied Materials, Inc., Santa Clara, California 95054 (US)
(72) Inventor: Tepman, Avi, Cupertino, California 95014 (US); Todd, Craig B., San Jose, CA 95117-2212 (US); Yu, James Enhao, Santa Clara, CA 95051 (US); Kim, Daehwan Daniel, Sunnyvale, California 94087 (US); Buchner, Chris, Santa Clara, CA 95054 (US); Kumar, Shiv, San Jose, CA 95120 (US)
(74) Representative: Kirschner, Klaus Dieter, Dipl.-Phys.

(57) **Abstract**

The present invention generally provides a modular vacuum processing system which includes a mainframe supporting a transfer chamber, one or more load locks and process chambers mounted to the transfer chamber, a modular mainframe plumbing tray and chamber trays associated with the process chambers. Methods of processing substrates and sequencing substrates through the system are also provided.

## Description

The present invention relates generally to substrate processing systems and methods of processing substrates. More specifically, the invention relates to modular vacuum processing systems methods of operation.

In the fabrication of integrated circuits and other electronic devices, including flat panel displays, vacuum processing systems are conventionally used to deposit and remove various conductive, semiconductive and dielectric materials onto and from substrates. These systems typically include one or more front-end load lock chambers. at least one transfer chamber and one or more processing chambers. At least two types of processing systems are generally known. One type of system is referred to as a single substrate processing system where the chambers are configured to process one substrate at a time. The other type of system is known as a batch processing system. In a batch processing system, multiple substrates are introduced into a process chamber and processed together. One advantage of single substrate processing systems is their ability to provide more uniform processing compared to batch systems. However, single substrate processing systems require substrates to be transferred between multiple processing locations on a single system, thereby increasing the time required to process and remove substrates from the system.

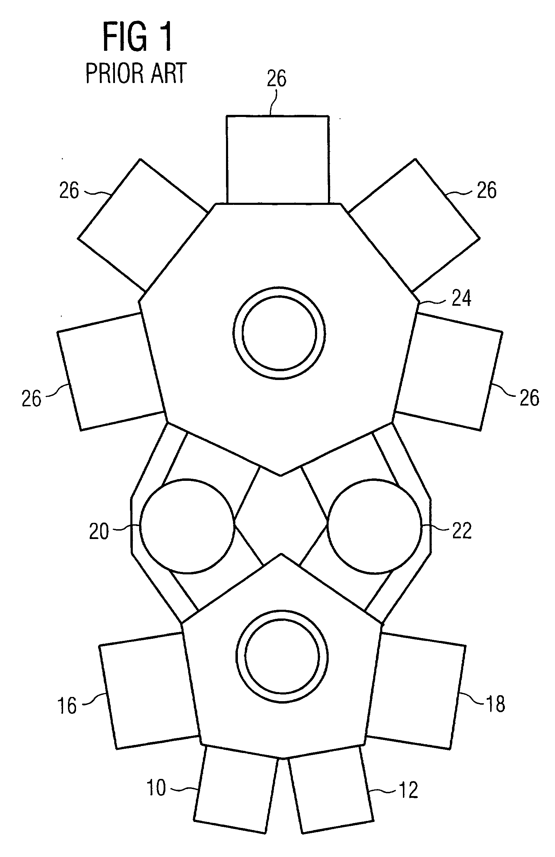

One disadvantage with conventional substrate processing systems which typically operate at ultra high vacuum, e.g., about 10⁻⁸ Torr, is that they rely on staged vacuum to achieve ultra high vacuum processing conditions. Figure 1 is a plan view of one processing system used to advantage in semiconductor processing. In operation, a plurality of isolated vacuum regions are interconnected, and each vacuum region is separately pressure controlled, so that wafers may be moved from region to region while the pressure level between the regions through which the wafer is passing is equalized. In such a staged vacuum processing system, substrates are typically introduced into one of two load locks 10, 12 at atmospheric pressure. The load lock is initially pumped down to an intermediate vacuum level substantially equivalent to that in a first transfer chamber 14 and individual wafers are transferred between the load lock and the first transfer chamber 14. The substrates can then be introduced into one or more pre-processing chambers 16, 18 such as an orienting chamber and/or a degas chamber. The substrates are then transitioned through one or more isolatable staging chambers 20, 22 where increasing high vacuum levels are achieved. Finally, the substrate enters a back end transfer chamber 24 maintained at ultra high vacuum where the substrates can be moved into desired processing chambers 26 that are also maintained at ultra high vacuum. Thus, in order to transition substrates from an intermediate pressure such as a roughing pressure of about 10⁻³ Torr to an ultra-high vacuum processing pressure (*i.e.* a pressure of >10⁻⁷ Torr), the substrates are transitioned from atmosphere to a transfer chamber maintained at a first intermediate pressure, then through an isolation chamber and then into another transfer chamber maintained at the ultra-high vacuum. While such a system may minimize the volume required to be maintained in the ultra-high vacuum range, the substrates need to pass-through the isolation chambers requiring additional substrate transfer steps and operation of the staging chambers which may increase the time required to process substrates in the system.

Another problem with conventional processing systems is that these systems have typically been manufactured to perform a specified processing sequence. As a result, conventional systems have not traditionally been easily reconfigured as processing sequences change or new processes are developed. In the assembly of these systems, the facility, *e.g.,* the process gases, the helium supply and return, the system exhaust, the electrical power, etc., were distributed from a central point in the fabrication facility to each chamber. As a result, systems have traditionally been assembled with the necessary plumbing connections running from each chamber to a point on the system where they could be connected to the fabrication facility facility. This has resulted in complicated plumbing lines being installed on the system which are difficult to remove and reconfigure to accommodate different chambers at each position on the system.

For example, conventional processing systems have a centrally located gas box or mass flow controller (MFC) distribution panel. Specific MFCs used depend upon the specific process chambers and processes to be conducted in the processing system. Because the gas box is centrally located on the mainframe, the piping that connects a particular MFC to a particular chamber varies depending on where the MFC is located in the gas box and where the particular chamber connection point is located. As a result, numerous gas line configurations, MFC arrangements, and chamber configurations are created. Once the chamber is positioned on the system and its gas lines are attached, the movement of that chamber to a different position on the system requires the gas lines to be re-configured. During the manufacture process of several systems, a chamber located in the same mainframe position on a different system may have a different gas line configuration because the position of the MFCs and respective gas lines will depend on where the chamber is in relation to other chambers on the system and how many MFCs were installed in support of the previously installed chambers.

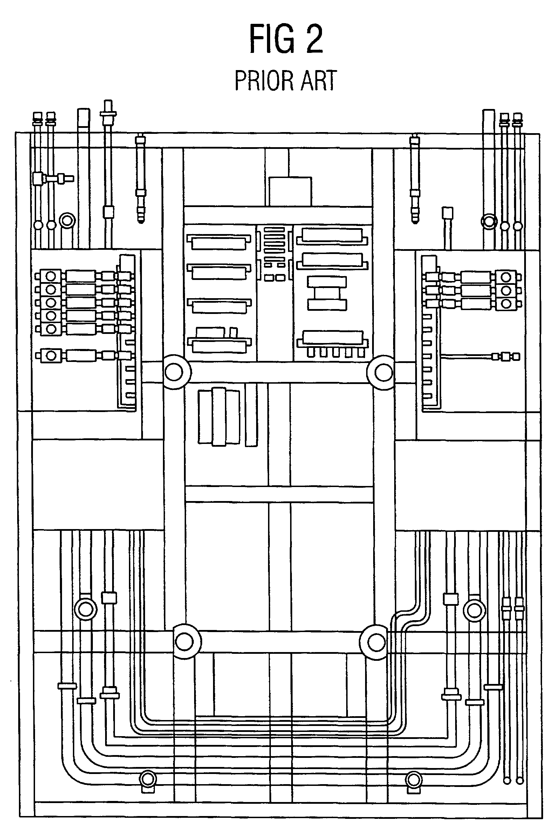

Figure 2 is a top down view of the facility and plumbing arrangement for a conventional processing system. As discussed above, MFCs for controlling the flow rate of gases supplied to the various processing chambers are arranged centrally on the mainframe depending upon the number and type of processing chambers to be mounted on the system. Therefore, the shape and length of the supply line attaching an MFC to its respective chamber will depend on mass flow controller position relative to other previously installed MFCs and to the chamber. Thus, gas supply lines from the MFCs will vary from system to system and from chamber to chamber, thereby requiring an almost infinite number of process supply lines to be manufactured to accommodate the variability with respect to mass flow controller and chamber attachment points.

A similar problem occurs with the distribution of control air or the pneumatic control system. Illustrated in the center of Figure 2, pressurized air is typically provided to centrally located air control valves on the mainframe. As with the mass flow controllers, the individual air control valves then send air signals out to the various chambers. As with the lines for the mass flow controllers, numerous variations of flexible line connections are required to provide control air signals to the various pneumatically actuated components on each of the different chambers and positions.

Also illustrated in Figure 2 is the U shaped arrangement of the facility that are supplied into each chamber. The variability with which these lines are provided to the chamber further complicates the connection of the chambers to the various facility supply points located within the main frame. This variability of the connection points between the main frame and the chamber have led to increasingly complex plumbing arrangements, difficulty of service, and increased complexity in performing routine maintenance functions. In addition, the manufacture of systems with such complex and variable plumbing arrangements is difficult and time consuming.

Therefore, there is a need for a modular vacuum processing system which can be easily maintained and/or reconfigured as needed in the field and which has a high throughput of substrates in a given amount of time.

The present invention generally provides processing systems and modular components thereof and methods of sequencing and processing substrates. In one aspect, an apparatus for processing substrates is provided which includes a transfer chamber, one or more load lock chambers connected to the transfer chamber, one or more process chambers connected to the transfer chamber, a modular plumbing tray disposed adjacent the transfer chamber and having facility connections for one or more of the process chambers and the load lock chambers, and a chamber tray disposed adjacent the one or more of the process chambers, load lock chambers and transfer chamber, the chamber tray having facility connections connected to one or more facility connections in the plumbing tray.

In another aspect, the invention provides a method of processing a substrate comprising introducing a substrate into a load lock chamber from atmospheric pressure, degassing and/or pre-heating the substrate in the load lock chamber while the load lock chamber is pumped to a vacuum level, introducing the substrate into a transfer chamber, and processing the substrate in one or more process chambers. In one aspect, a heating element is activated while the load lock chamber is pumped to a vacuum level. The method may further include introducing the substrate into the load lock chamber, cooling the substrate in the load lock chamber, and then venting the load lock chamber to atmospheric pressure.

In another aspect, the invention provides an apparatus for distributing facility to devices on a processing system comprising an enclosure having at least one facility interface and one or more chamber interfaces and one or more of a process gas manifold, vacuum manifold, water manifold and a helium manifold disposed in the enclosure connected between the at least one facility interface and the one or more chamber interfaces.

In another aspect, the invention provides an apparatus for distributing facility comprising a support frame having one or more of an electronics box, a gas panel, a vacuum line and a controller device disposed thereon.

In another aspect, the invention provides a method of processing substrates comprising positioning a pair of substrates on two blades on separate robots in a processing system, moving the substrates in parallel to a pair of first process chambers, and then moving the substrates in parallel to a pair of second process chambers. In one aspect, the substrates are moved nearly simultaneously into the first and second pair of process chambers. Further, in one aspect, the robots are disposed in a common transfer volume.

In another aspect, a modular processing system is provided which includes a mainframe support, a transfer chamber module connected to the mainframe, one or more load lock chambers connected to the transfer chamber, one or more process chambers connected to the transfer chamber, a modular facility tray disposed adjacent the transfer chamber; and one or more chamber trays disposed adjacent one or more of the process chambers.

So that the manner in which the above recited features. advantages and objects of the present invention are attained and can be understood in detail, a more particular description of the invention, briefly summarized above, may be had by reference to the embodiments thereof which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a top plan view of a conventional processing system.

Figure 2 is a schematic view of facility lines in a conventional processing system.

Figure 3 is an isometric view of one embodiment of a processing system of the invention.

Figure 4A is a top plan view of one embodiment of a processing system of the invention.

Figure 4B is a schematic cross sectional view of a lift of the invention.

Figure 4C is a schematic cross sectional view of a load lock of the invention.

Figure 5 is a simplified isometric view of one embodiment of a processing system of the invention.

Figures 6 and 7 are isometric views of one embodiment of a mainframe plumbing tray of the invention.

Figure 8 is a top plan view of one embodiment of a mainframe plumbing tray of the invention.

Figure 9 is a side view of a facility interface of a mainframe plumbing tray of the invention.

Figure 10 is a side view of three chamber interfaces of a mainframe plumbing tray of the invention.

Figures 11A and 11B are isometric views of one embodiment of a chamber tray of the invention.

Figure 12 is an isometric view of a gas line manifold disposed in a plumbing tray.

Figure 13 is an isometric view of a helium (inert fluid) manifold disposed in a plumbing tray.

Figure 14 is an isometric view of a system vacuum manifold disposed in a plumbing tray.

Figure 15 is an isometric view of a water supply and return manifold disposed in a plumbing tray.

Figure 16 is an isometric view of a mainframe plumbing tray illustrating the relationship of each of the facility.

Figure 17 is a cross sectional view of a mainframe plumbing tray illustrating the relationship of each of the facility.

Figure 18 is a top plan view of a mainframe plumbing tray connected to six chamber trays.

Figure 19 is a front view of a modular DC power supply.

Figure 20 is a front view of a modular AC load center.

Figure 21 is a schematic view of a system controller.

Figure 22 is an isometric view of an electronics rack and cooling system.

Figure 23 is a schematic view of a modular equipment rack.

Figures 24 and 25 are isometric views of an alternative embodiment of a monolith of the invention.

Figures 26 and 27 are schematic views of a system showing a process sequence.

Figures 28-52 are schematic views of a processing system showing processing stages.

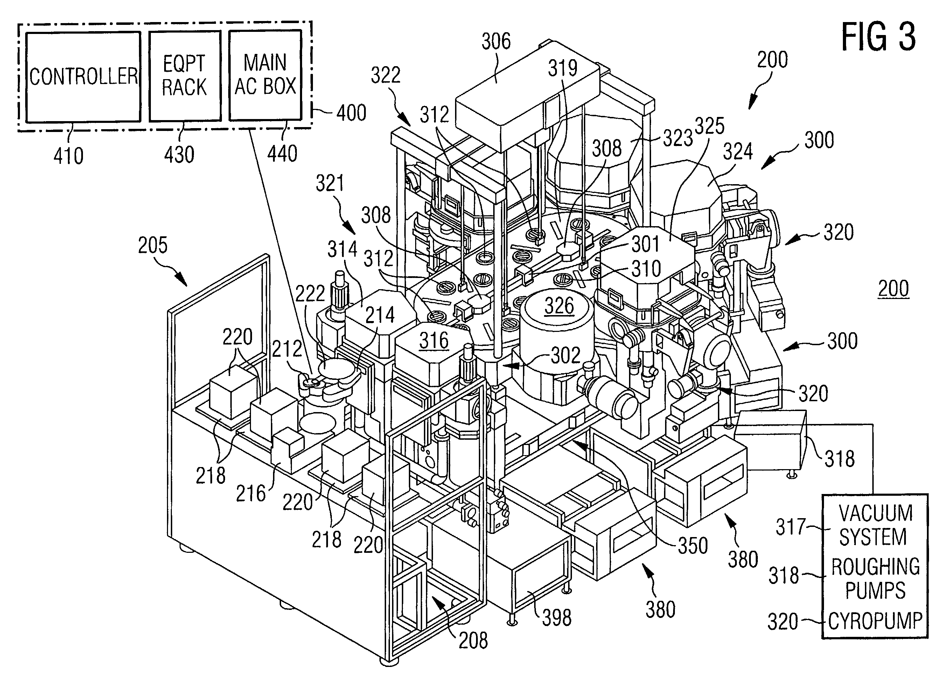

Figure 3 is an isometric view of one configuration of an automated processing system 200 according to the present invention. Automated processing system 200 generally includes factory interface 205, mainframe 300, and auxiliary systems 400. Mainframe 300 generally includes a transfer chamber or transfer chamber 302, one or more single substrate load locks 314, 316, process chambers 322-326 (chamber position 321 is shown without a chamber mounted to the monolith), a main frame plumbing tray 350, and chamber trays 380. Process chambers can be mounted at any one of at least six process positions provided on the transfer chamber 302. While a configuration is shown with six process chamber positions, configurations having eight (8) or ten (10) processing chambers mounted on an extended transfer chamber 302 is also contemplated by the invention. Two single wafer load locks 314, 316 are mounted on the front end of the transfer chamber 302 to transition substrates between atmospheric pressure from the factory interface 205 to a vacuum level within the transfer chamber 302. Mainframe 300 may support on-board vacuum pumps to provide roughing vacuum (typically in the range of about 10⁻³ Torr) to load locks 314, 316, transfer chamber 302 and process chambers 322-326. The vacuum pumps can be positioned below the mainframe in a sub fab or basement, or on the same level as the mainframe. Alternatively, an on-board vacuum pump 318 may be located on the mainframe at the point of use. Generally, a single vacuum pump is sufficient to provide roughing vacuum (e.g., a pressure of about 10⁻³ Torr) for the two single substrate load locks 314, 316, the transfer chamber 302 and six PVD type process chambers. Additional roughing pumps 318 may be added for processes which have high process gas flow rates or when it is desired to operate a chamber with a dedicated roughing pump. For example, in a processing system having two pre-clean chambers and four PVD chambers. For example, one roughing pump is coupled to and provides roughing vacuum to each of the four PVD chambers, the load locks 314, 316 and the transfer chamber 302 and the other pump is coupled to and provides roughing vacuum to each of the two pre-clean chambers.

A vacuum system 317 is coupled to transfer chamber 302 and includes roughing pumps 318 and cryo-pumps 320 which operate to provide and maintain high vacuum to ultra-high vacuum pressure (e.g., about 10⁻³ to about 10⁻⁷ Torr) in transfer volume 299. Process chambers 322-326 are coupled to transfer chamber 302 and are maintained in the high vacuum to ultra-high vacuum pressure range (e.g., about 10⁻³ to about 10⁻⁷ Torr) depending upon the process to be conducted within the chamber. Vacuum within the process chambers may be provided by a cryo-pump/roughing pump combination. The cryo-pump 320 can be attached to the chamber (as illustrated on chambers 324 and 325) and the roughing pump can be an on-board vacuum pump 318 attached to the mainframe 300. As with process chambers 322-326, single substrate load locks 314, 316 are also provided with a cryo-pump and roughing pump.

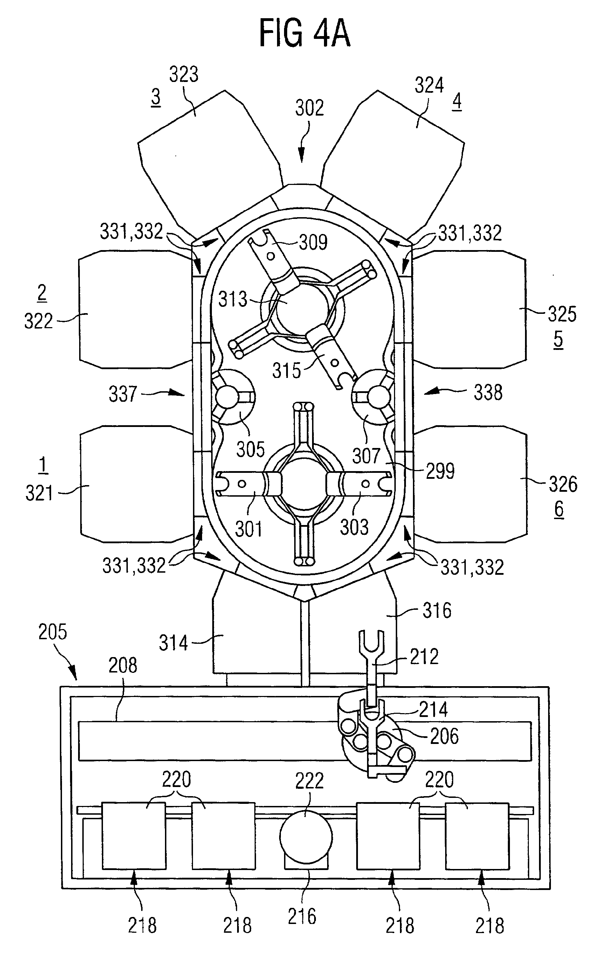

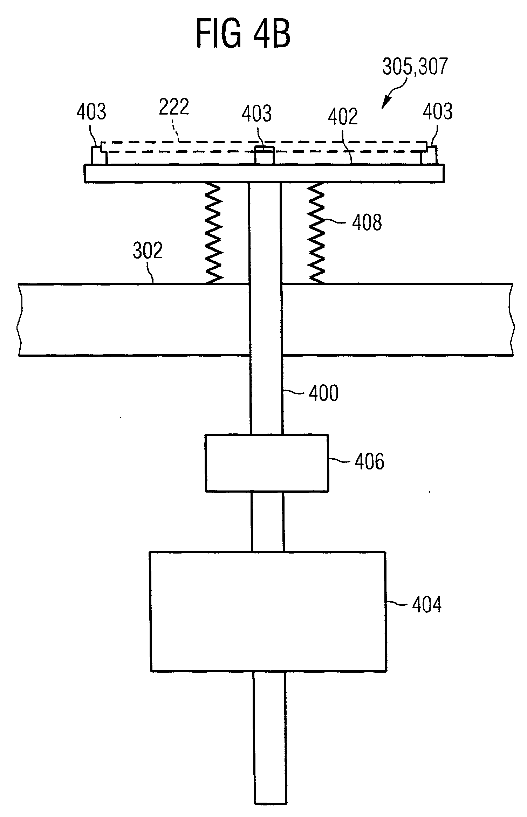

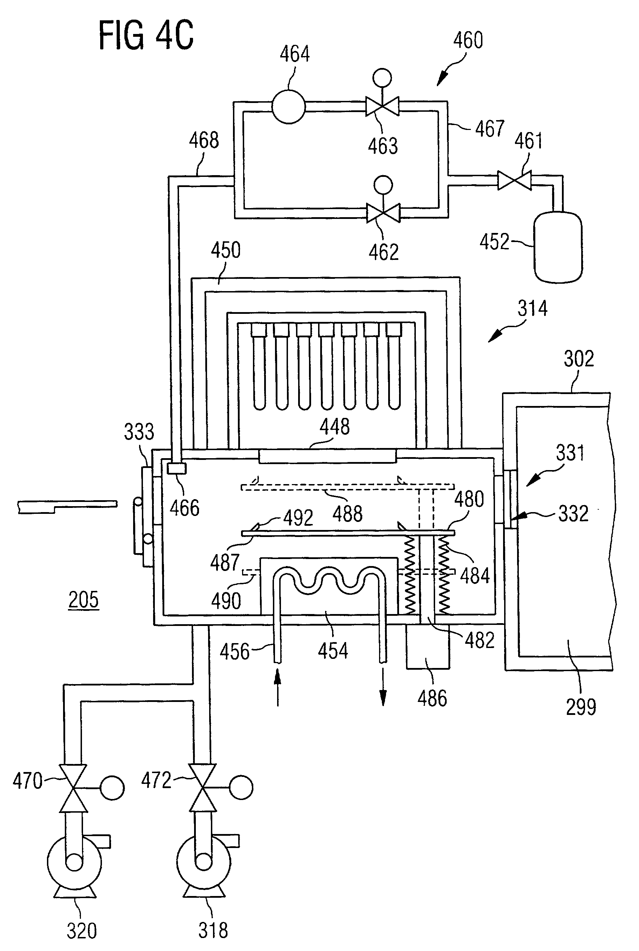

Lid 304 is movably disposed over the top of the monolith on a support frame. A lid lift mechanism 306 is provided to lift lid 304 from transfer chamber 302 to allow access to transfer volume 299. The lid is sealably connected on top of transfer chamber 302 in a closed position to form transfer volume 299. Lid 304 includes a plurality of view ports 312 disposed therethrough which provide visible access into transfer volume 299. A wafer sensing system 319 is located on top of lid 304. Wafer sensing system 319 includes hubs 308 and sensors 310. Sensors 310 are located above view ports 312 and detect the presence or absence of a substrate or other work piece on the blade of the transfer robots 311, 313 (shown in Figure 4) disposed within the transfer volume 299.

Factory interface 205 includes an atmospheric robot 206, atmospheric substrate orienter 216, and wafer storage positions 218 (four shown). Factory interface 205 and mainframe 300 are located within a wafer processing facility or clean room. In addition, factory interface 205 and mainframe 300 may be enclosed in a controlled, clean environment so that substrates exposed to the atmosphere between factory interface 205 and mainframe 300 are not contaminated. In either case, substrates 222 may be handled by atmospheric robot 206 between wafer storage positions 218, atmospheric orienter station 216, and single substrate load locks 314, 316 without risk of contamination. Atmospheric robot 206 is capable of moving between positions in front of storage positions 218, orienter 216 and load locks 314, 316. Atmospheric robot 206 includes movable blades 212 and 214. One exemplary robot 206 is available from Rorze, Automation Inc. of Milpitas, California under the product name RR701 series robot. Trackless robots (model number UTM 3000 and UTM 3500) such as those sold by MECS Corp. of Aichi, Japan could also be used to advantage in the system.

Auxiliary systems 400 include a system controller 410, an equipment rack 430 and a main AC box 440. System controller 410 includes a computer system and various electronics for controlling the operation of automated processing system 200. Equipment rack 430 supports power supplies, RF generators and other devices used in the processing of substrates within processing system 200. Main AC box 440 receives 200 volt, three phase, 400 amp electrical power from the wafer processing facility. The electricity is then conditioned, transformed (as needed) and distributed to each of the processing chambers, pumps, compressors, heat exchangers and other electrical loads included in processing system 200. Vacuum pumps can be located on the mainframe, for example, between chambers 322 and 323 and chambers 325 and 324.

Figure 4A is a top schematic view of processing system 200 which includes transfer chamber 302, factory interface 205, two single substrate load locks 314, 316 and six processing chambers 321-326 located at positions 1-6. The lid 304 has been removed to expose transfer volume 299 and the components within transfer volume 299. The transfer chamber 302 has an elongated hexagonal shape formed from a seamless, machined aluminum block. The elongated hexagonal shape provides at least six processing chamber positions and two load locks 314, 316. Alternatively, the transfer chamber could be formed from a support frame and skins sealably mounted over the support frame.

Transfer robots 311 and 313 and transfer lifts 305 and 307 are located within transfer volume 299 to enable substrates to be moved from the factory interface to each of the process chambers 321-326 as required by the process sequence performed by the tool. Transfer robots 311, 313 move substrates between load lock chambers 314, 316, the process chambers 321-326 and the lifts 305, 307. The lifts 305, 307 include support pedestals which are at least partially disposed in the transfer chamber. The lifts 305, 307 are preferably movable in at least a vertical direction, but may also rotate. The lifts 305, 307 are described in more detail below.

Disposed within transfer volume 299 and transfer chamber 302 are access ports 331 and slit valves 332 which provide access to and isolate, respectively, each of the load locks 314, 316 and processing chambers 321-326 from the transfer volume 299. The access ports 331 are formed in the walls of transfer chamber 302 adjacent each process position supporting process chambers 321-326 and the load locks 314, 316. Slit valves 332 are disposed through the floor of the transfer chamber 302 and provide isolation via sealing doors between transfer volume 299 and each of the process chambers 321-326 and load locks 314, 316. The transfer robots 311, 313 and lifts 305, 307 are provided for moving work pieces to and from the load locks 314, 316 and processing chambers 321-326. Each transfer robot 311, 313 is coupled to motors (not shown) which extend and retract the primary and auxiliary blades 301, 303 and 309, 315, respectively, and allow the robot to rotate. Primary blade 301 and an auxiliary blade 303 of transfer robot 311 transfer substrates between load locks 314, 316 and process chambers 321, 326 located in positions 1 and 6 and lifts 305, 307. Primary blade 309 and an auxiliary blade 315 of transfer robot 313 transfer substrates between lifts 305, 307 and process chambers 322-325 located in positions 2, 3, 4, and 5.

In operation, atmospheric robot 206 moves along slide position 208 to transfer substrates 222 from any of the wafer storage positions 218 onto either of the movable blades 214, 212. Once on movable blades 214, 212, substrates 222 are transferred to the orienter 216. However, substrates 222 may be transferred directly into either of the single substrate load locks 314, 316. After being oriented by atmospheric orienter 216, oriented wafers are transferred via atmospheric robot 206 into either of the single substrate load locks 314, 316. While an atmospheric robot with only a single blade may be used, a dual blade robot 206, as illustrated in Figure 3, is preferred. A dual blade robot can perform substrate exchanges or substrate swaps without requiring placement of a retrieved substrate prior to placement of another substrate into the position from which a first substrate is removed. In a substrate exchange, a substrate positioned in a single substrate load lock 314, for example, is unloaded with empty movable blade 212 and an oriented substrate 222 positioned on movable blade 214 positions the oriented wafer in the single substrate load lock 314. The oriented wafer placed in single substrate load lock 314 is then pre-heated and degassed as desired while the processed substrate is returned, via robot 206, to a cassette 220 at the appropriate storage position 218. In much the same way, where an oriented wafer is positioned on atmospheric orienter 216, robot 206 with an empty movable blade 214 can transport a non-oriented wafer to orienter 216 on movable blade 212, remove the oriented wafer with moveable blade 214 and then place the non-oriented wafer on blade 212 onto atmospheric orienter 216. Thereafter, if a processed wafer is waiting to be removed from single substrate load lock 316, for example, robot 206 with an oriented wafer on movable blade 214 and an empty movable blade 212 could then rotate and translate via slidable position 208 to a position adjacent to single substrate load lock 316. The processed wafer is then removed by movable blade 212 and the oriented wafer on moveable blade 214 is placed in single substrate load lock 316. Robot 206 rotates and then translates via slidable position 208 to place the processed substrate into the desired cassette 220.

Figure 4B is a cross sectional schematic view of a lift 305, 307 The lift generally includes a support shaft 400 which extends at least partially through the transfer chamber 302 and supports a pedestal 402 on its upper end. Lift fingers 403 are mounted to the pedestal and support a substrate 222 thereon when moved into a substrate lift position. A lift assembly 404, such as a stepper motor or the like, is mounted below the transfer chamber and connected to the shaft 400 to move the shaft up and down within the transfer chamber. A rotational assembly 406 can also be connected to the shaft 400 to provide rotational movement to the pedestal 402 in the transfer chamber. A bellows 408 is connected between the shaft 400 and the transfer chamber 302 to provide necessary sealing between the shaft and the transfer chamber. A conventional lift is provided by Applied Materials, Inc. located in Santa Clara, California. Lifts 305, 307 are used as hand off points between transfer robots 311, 313. Additionally, lifts 305, 307 are used to maintain the desired orientation of a substrate 222 as the substrate moves through processing system 200.

One advantage of automated processing system 200 is that substrate orientation occurs outside of the processing volume 301. Substrates are oriented in the atmospheric orienter 216 and then orientation is maintained as the substrates move through the various processing positions on the processing system 200. Substrate orientation is maintained by lifts 305, 307 which rotate through a predetermined angle so that the substrate is presented in the same orientation to robot 313 as the substrate was oriented to robot 311. Thus, substrates 222 can be oriented in atmospheric orienter 216 prior to loading into transfer chamber 302 and lifts 305, 307 can maintain substrate orientation as substrates 222 move through the various processing positions 1-6. For example, one representative predetermined angle of rotation is about 101 degrees. Thus, a substrate loaded onto lift 307 from robot 311 with the substrate notch pointed towards robot 311 can be rotated clockwise through an angle of about 101 degrees so that the substrate notch points towards the center of robot 313. As a result, substrate orientation is maintained so that the same substrate orientation is presented to chambers located in positions 2-5. After processing in chambers located in positions 2-5 is complete, substrates must be placed on either of the lifts 305, 307 in order to be handled by transfer robot 311 for placement into one of substrate load locks 314, 316, or process positions 1 and 2, according to the specific process sequence being conducted.

Figure 4C is a cross sectional view of one load lock 314. Load lock 316 is similarly arranged. Single substrate load locks 314, 316 are mounted between the factory interface 205 and the transfer chamber 302. Each single substrate load lock 314, 316 includes a heat source 450, such as a lamp array, for heating and degassing substrates to remove volatile contaminants before transferring the substrates into the processing internal volume 299 and thence to a processing chamber. Heat source 450 is separated from the load lock internal volume by quartz window 448. Additionally, a substrate support pedestal 454 provided within each of the single wafer load locks 314, 316 are water cooled via conduit 456 disposed within support 454 with a water cooling system 362 to assist in the substrate cool down function. A lift hoop 480 is provided within the single substrate load lock for accepting substrates from and placing substrates on robot blades 212, 214, 301, and 303. Lift hoop 480 is supported by support shaft 482 which is coupled to a suitable lift assembly 486. Lift assembly 486 between desired positions such as transfer position 487, raised or degas position 488 (shown in phantom), and a cool down position 490 (shown in phantom). It is to be appreciated that the substrate is supported by fingers 492 and can be positioned in the degas position 488 so that radiant heat source 450 can heat the substrate as the load lock is evacuated to the transfer pressure. During cooling, support hoop 480 moves to cool down position 490 such that the substrate is placed on and cooled by support pedestal 454. The internal volume of the single substrate load locks 314, 316 is minimized so that the time required to transition from atmospheric pressure to vacuum pressure is reduced. The minimized internal volume of the load locks 314, 316 in conjunction with the combined availability of a roughing pump 318 and cryo-pump 320 provides an ability to transition the load locks 314, 316 from atmosphere to a transfer pressure of greater than about 10⁻⁷ Torr in a matter of seconds. While such rapid pump timers are available, the actual pressure transition time is determined by the desired pre-heat and degas sequence. Completely processed substrates exiting transfer chamber 302 are loaded into one of the load locks 314, 316 where the water cooled substrate support 454 within the load lock 314, 316 acts as a heat sink to assist in the substrate cool down process. The cool down process is effectuated by providing a vent gas which is typically an inert gas, such as, for example, argon or nitrogen, to the internal volume of the load lock as the load lock transitions from the high vacuum transfer pressure to atmospheric pressure. Each of the single substrate load locks 314, 316 can perform the pre-heat, degas and cool down functions for the substrates processed in automated processing system 200.

A gas supply system 460 which is in communication with the internal volume 454 of the single wafer load lock 314, 316. Gas supply system 460 includes isolation valves 461, 462, 463, meter valve 464 and a diffuser 466. Conduits 467 and 468 couple the various components with the internal volume of load lock 314, 316. In one embodiment, the gas supply system 452 is used to provide an inert gas for quickly venting without generating particles within the single substrate load lock. As used here, a metering valve 464 is adjusted to provide laminar flow of gas into the single substrate load lock and then after a given time, the gas supply system shifts over to another line which allows higher gas flow. It is believed that by providing metered laminar flow of gas to fill the single substrate load lock internal volume before switching to the higher flow rate, particle generation is minimized. Also in communication with the internal volume of single substrate load lock 314 is roughing pump 318 and cryo-pump 320 each of which is isolated from the internal volume of load lock 314, 316 by isolation valves 472 and 470, respectively. A roughing pump 318 is used to evacuate the internal volume of single substrate load lock 314 to roughing vacuum. Cryo-pump 320 is then used to further evacuate the internal volume of single substrate load lock 314 to provide high vacuum in a range of about 10⁻² to about 10⁻⁷ torr in order to facilitate transfer of substrates from single substrate load lock 314 into internal transfer volume 299 which is also maintained at a suitable high vacuum.

In operation. substrates are loaded into a single substrate load lock 314 and placed on the pedestal lift hoop 480 for preheat/degas and for cool down. One representative operation of single substrate load lock 314 is to provide degas, preheat and facilitate the transfer from atmosphere into the reduced operate vacuum of internal transfer volume 299. A substrate loaded into single substrate load lock 314 is heated by radiant energy generated by a lamp module 450 which is transferred through the quartz glass 448 onto the wafer. Additionally, gas supply system could be used to provide an inert gas to scavenge the load lock of desorbed gases. After the preheat and degas is complete, preheated and degassed substrate can be transferred into the transfer volume 299 once the single substrate load lock 314 is evacuated to the appropriate vacuum level. The cryo-pump 320 and roughing pump 318 would work in concert to provide rapid evacuation of the internal volume of single substrate load lock 314. Additionally, single substrate load lock 314 acts as a cool down chamber for post processing cool down of substrates processed in automated processing system 200. In this way substrates exiting the transferring volume 299 after processing are placed on the substrate support within the single substrate load lock 314. Cooling water is provided through the pedestal 454 to provide cooling. In addition, an inert gas is provided into single substrate load lock 314 to further facilitate the transition of single substrate load lock internal pressure from very high vacuum to atmosphere to further the transfer of the substrate from the single substrate load lock 314 into a storage cassette 220 on a storage position 218 in factory interface 205. This should be appreciated that by providing gas into the single substrate load lock 314, the single substrate load lock 314 can be maintained at a slightly high pressure so that contamination and moisture from the outside atmosphere near the factory interface does not enter into the single substrate load lock 314 thereby incurring moisture and defeating the ability of the single substrate load lock 314 to perform the preheat and degas functions. Additionally, the slight over pressurization of the single substrate load lock 314 reduces the possibility that particles or contaminants from outside the atmosphere in vicinity to the factory interface 205 are prevented from entering the internal volume of single substrate load lock 314.

It is to be appreciated that the cool down function performed in a processing system 200 according to the present invention is furthered by having the cool down function performed within the single substrate load lock 314 on a cooled platen vented from reduced pressure to atmosphere. Additional cooling occurs while the substrate is handled by robot 206 for placement within the storage cassettes 220 on a storage position 218 on the factory interface 205. Thus, the cooling of the substrate occurs during the handling operation, further improving the cool down efficiency of the system.

The process gas supply system to the single substrate load locks serves a dual purpose. In a venting configuration, the gas supply provides a volume of gas into the internal volume of the single substrate load lock 314 by a metering valve 464. After a volume of gas is flowed into the chamber, then the full flow can be turned on providing more rapid pressurization and venting to achieve a rapid venting sequence of the single substrate load lock 314 and thereby further increase throughput. In an alternative embodiment, an MFC may be provided to allow more precise gas control. Thus, a degas recipe performed with this embodiment can be flowed completely by a mass flow controller according to a desired degas recipe.

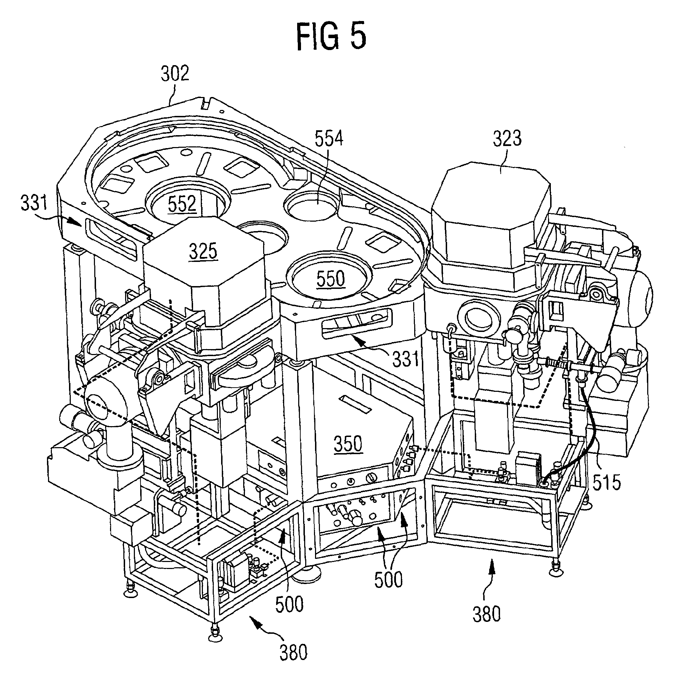

Figure 5 illustrates an isometric view of the transfer chamber 302, the main frame plumbing tray 350 and two chambers 323, 325 connected to the transfer chamber 302 with a chamber tray 380 disposed below each of the chambers. Access ports 331 are provided in the transfer chamber 302 at the chamber positions and the load lock positions. Openings 550, 552 are provided to mount transfer robots 311, 313 (shown in Figure 4A). Openings 554 and 556 (not shown) are provided in the transfer chamber to mount the lifts 305, 307.

The plumbing tray 350 is disposed below the transfer chamber 302 and includes the plumbing to distribute each of the processing facility needed to support the transfer chamber 302, the load locks 314, 316 and the process chambers 321-326 connected to the transfer chamber. The plumbing tray 350 includes a plurality of chamber interfaces 500 disposed around the perimeter thereof. Chamber interfaces 500 are positioned adjacent to each of the chamber positions 1-6, the load lock positions and two centrally located transfer chamber positions. The chamber interfaces 500 provide connections for necessary facility to the chamber trays 380. The chamber trays 380 provide the necessary facility to their respective process chambers, load locks or transfer chamber from the chamber interface 500. The plumbing tray 350 includes an enclosure in which the plumbing lines are located. The plumbing lines are shown in more detail below in figures where the enclosure is partially removed for clarity.

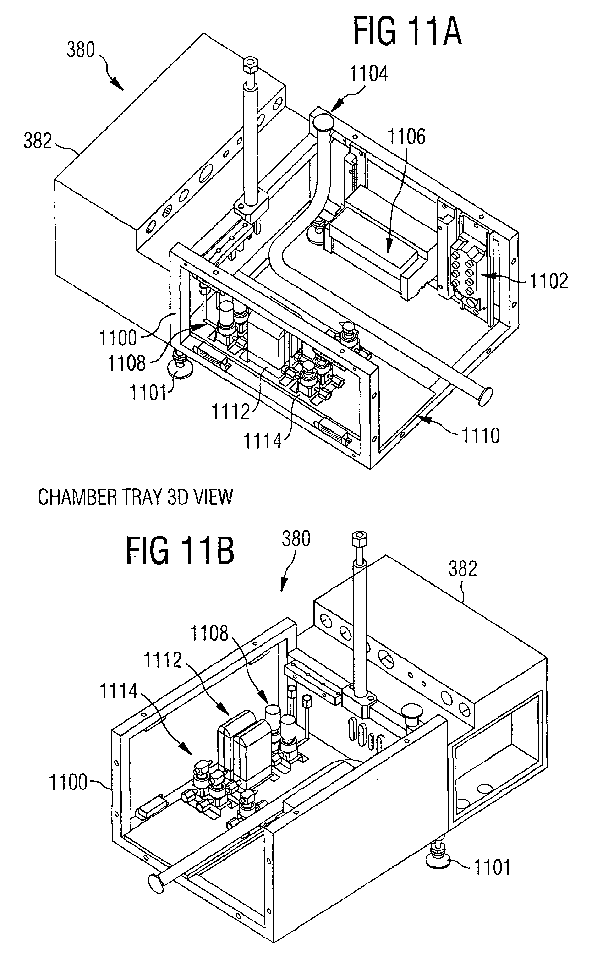

Figure 5 illustrates a connection for a process gas from a chamber interface 500 on the main frame plumbing tray into a MFC 1112 (shown in Figures 11A and B) on chamber trays 380 of process chambers 323, 325. The connection lines between the chamber interfaces 500 and the MFCs 1112 are similarly configured as a result of the modular design of the plumbing tray 350 and chamber tray 380. The plumbing connection from a point on the outlet side of the MFC to the processing volume of the chamber, is the same regardless of chamber position. Thus, by standardizing the MFC outlet relative to the processing chamber inlet, the same gas supply line can be used to connect the MFC outlet to the processing volume inlet. Other gas supply lines may be needed depending on chamber type. However, identical chamber types can use similar process lines. The use of similar components, such as gas lines in this example, simplify manufacturing and assembly of the system by enabling mass production of identical lines and testing of these components before they are installed on the system. Each of the chamber interfaces 500 and the chamber trays for specific chambers can be similar to enable easy re-configuration and/or maintenance, including replacement of components, of the system. In the embodiment shown, the chamber trays are mounted separately to the mainframe. In an alternative embodiment, the process chamber and the chamber tray could be mounted on a single support frame that is mounted to the mainframe and transfer chamber. The support frame could include adjustable feet or rollable support members to enable the support frame with the chamber and chamber tray to be rolled into position adjacent the system and connected thereto. Also, Figure 5 shows a vacuum line 515 extending between a vacuum connection on the chamber tray and a vacuum line on chamber 323. An identical line (not shown in this view) is provided on chamber 325.

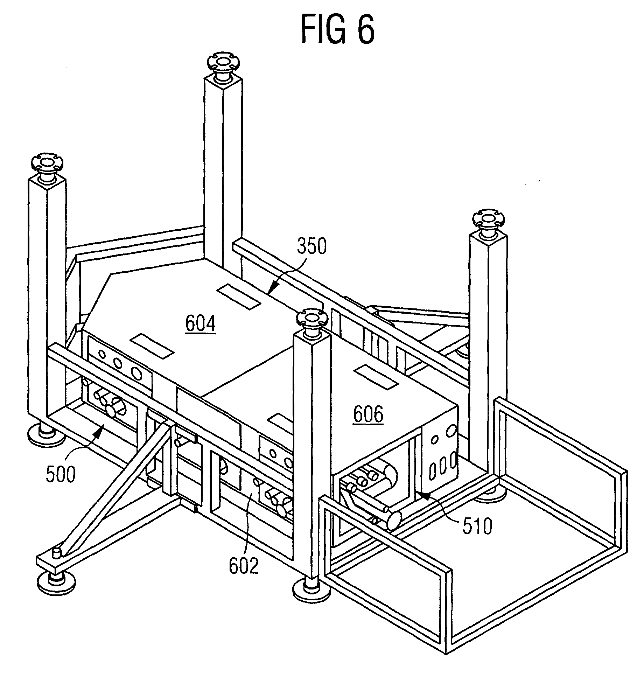

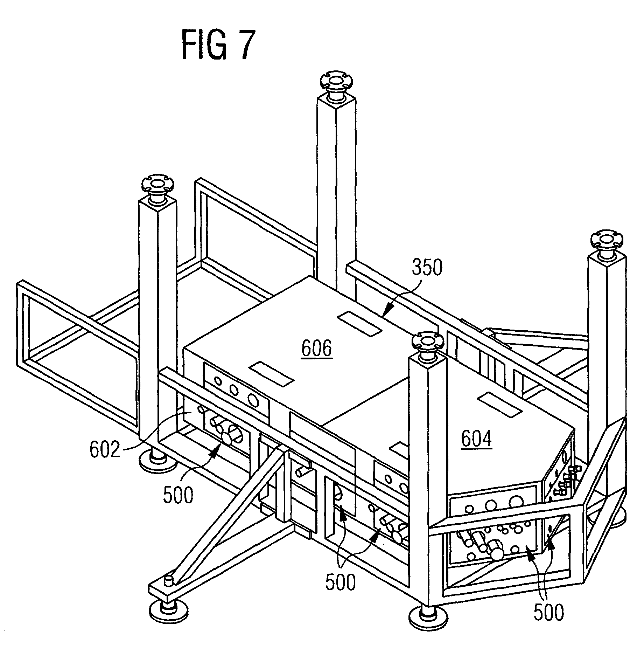

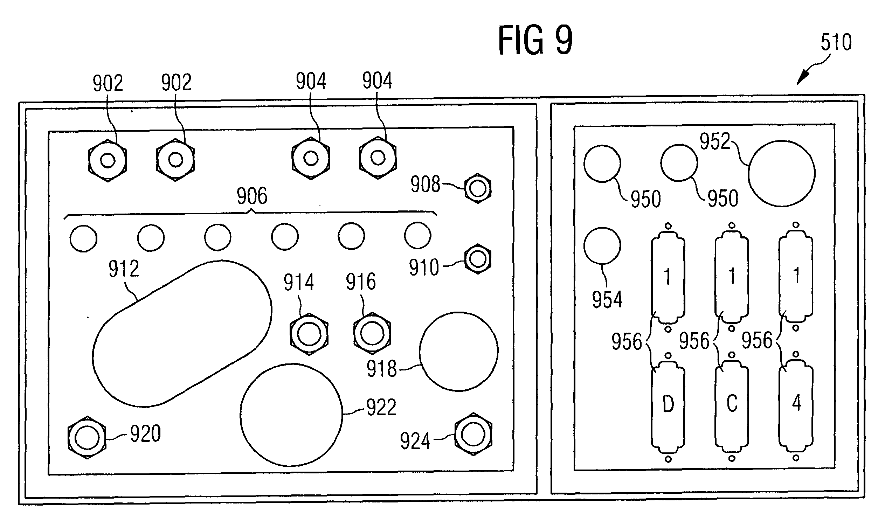

Figures 6-7 are isometric views of the main frame illustrating the facility interface 510 (shown in Figures 6 and 9) and the chamber interfaces 500 (shown in Figures 6, 7 and 10) of the plumbing tray 350. The plumbing tray 350 is supported on the mainframe below the transfer chamber. The facility from the fabrication facility are connected to the plumbing tray 350 at the facility interface 510 and distributed within the plumbing tray to each of the chamber interfaces 500. Preferably, the facility interface 510 is commonly located on each system to simplify installation within a fabrication facility. Additionally, each chamber interface 500 is preferably identical to simplify connection between the mainframe and the process chamber mounted thereto irrespective of the type of process chamber and the position of the mainframe. Each of the chamber interface connections are preferably identical so that irrespective of chamber position, chamber trays can be manufactured and mounted to the main frame with minimal plumbing required. The chamber trays can be configured to connect to a common chamber interface and distribute the facility to proper locations on a particular chamber for which the chamber tray is configured.

A containment housing 602 is disposed around the plumbing tray 350 and includes a containment floor. The containment floor is used to contain fluids within the plumbing tray which may leak due to piping failure, broken fittings or loose connections. Removable cover panels 604, 606 are provided to enable easy access into the plumbing tray. The containment floor can be formed from a drip pan having a circumferential lip formed around the perimeter of the containment floor.

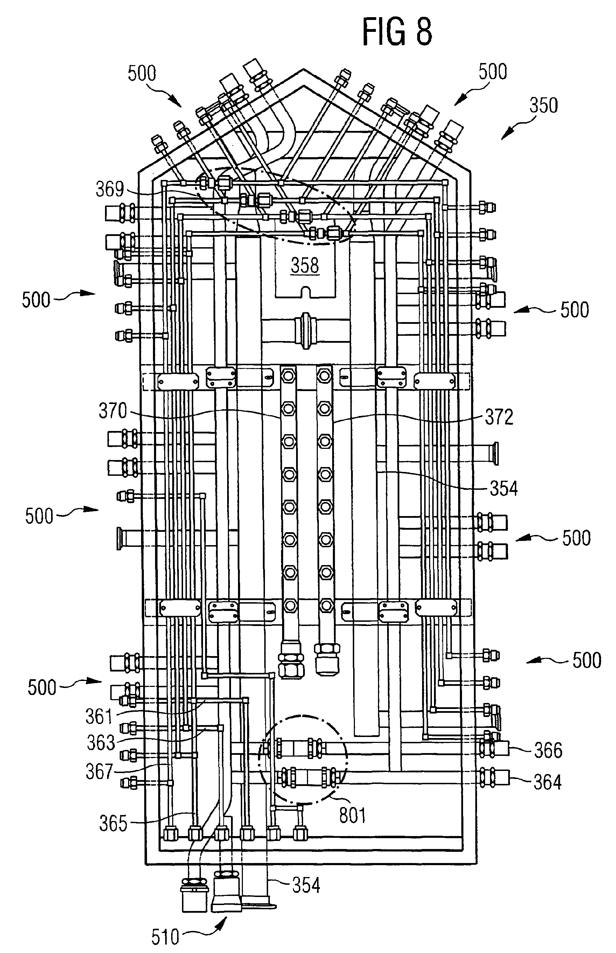

Figure 8 is a top view of the mainframe plumbing tray 350 having the top cover removed. The facility interface 510 is located on one end of the plumbing tray and the various conduits located within the plumbing tray are distributed from the facility interface 205 (shown in Figure 4A). Each of the conduits within the plumbing tray are preferably disposed in vertically spaced envelopes. Within each of the envelopes, the various conduits are disposed in alternating U-shaped layouts to provide access to break points or connections in each of the conduits. Each conduit includes at least one break point or connection so that the conduits can be disassembled and removed for servicing, maintenance and/or replacement. Each conduit within the plumbing tray 350 includes an interface for each chamber position including the load locks, process chambers and the transfer chamber.

In the embodiment shown in Figure 8, the facility systems include a centrally located water supply manifold 370 and a systems exhaust manifold 372 in the lowest vertical envelope.

The water supply manifold 370 is shown having a connection for each chamber position and a supply connection for each of the load locks 314, 316. The system exhaust manifold 372 includes an exhaust port for each one of the chambers, the load locks and the transfer chamber. Load locks 314, 316 share a common exhaust port which is disposed adjacent to the coupling.

Each chamber is provided with a vacuum port coupled to a roughing pump or cryo-pump for exhausting excess process gases and volatile process by-products. Outward of the water inlet supply and return in an adjacent vertical envelope is the system vacuum manifold 354. Outward of the system vacuum manifold 354 and in the adjacent vertical envelope is the liquid helium manifold having a liquid helium supply 364 and return 366. Outward of the liquid helium manifold and in the adjacent vertical envelope are the gas lines, such as nitrogen vent gas line 361, spare gas line 363, nitrogen process gas line 365 and argon process gas line 367. Break points or connections 369 are provided for each of these gas lines. Each system in the plumbing tray also includes the break points 369 that are preferably located at one end of the mainframe. The system connections preferably alternate from one end of the mainframe to the other in adjacent vertical levels to provide unobstructed access to the connections at each level.

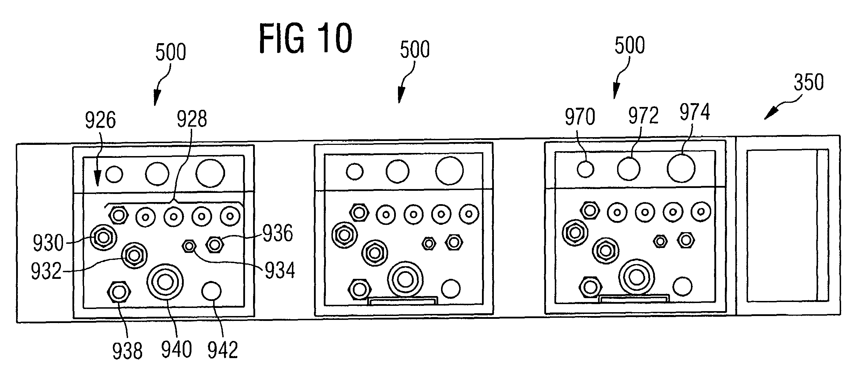

Also shown in Figure 8 is a pneumatics distribution fitting 358 disposed on the back end of the mainframe. Control air is supplied from the fabrication facility to the distribution fitting 358 via the mainframe facility interface 510. Seven connection ports are provided by the pneumatics distribution fitting 358. Six of the ports (e.g., one port for each chamber interface) are coupled to each of the chamber interfaces for chamber pneumatic operation. The seventh port is coupled to additional pneumatic distribution manifolds for mainframe pneumatic component operation.. From the distribution fitting 358, control air is distributed via suitable tubing, such as flexible hoses or polyurethane lines, to pneumatic connections at each chamber interface (Figure 10) and from there to the chamber pneumatic control manifold. Each chamber pneumatic control manifold includes a plurality of air control valves for distributing pneumatic control air to the various pneumatically operated components of the associated processing chamber. After actuating the pneumatic component, the control air is exhausted from the pneumatic control manifold on the chamber tray to the air exhaust chamber interface (shown in Figure 10) and thence to the system exhaust manifold 372. Two additional pneumatic distribution manifolds, similar in construction to the pneumatic distribution manifolds in the chamber trays, are provided for supplying control air to pneumatically actuated components on the transfer chamber and single substrate load locks. For example, one manifold could be provided for the actuation of each of the slit valves 332 and another could be provided that includes control valves for actuating other transfer chamber and single substrate load lock pneumatic components such as, for example, transfer chamber gate valves, external doors 333 on each of the load locks 314, 316, lifts 305, 307 and the wafer lift 460 inside each load lock 314. 316.

The facility lines in Figure 8 are arranged in a manner so that the water supply manifold 370 is on the bottom of the plumbing tray 350 and the pneumatic distribution box 358 is in front of the water supply manifold on the bottom of the tray. The lines include process gas lines in the uppermost array, helium supply and return in the middle and vacuum lines on the bottom. The vertical distribution of the facility lines in the plumbing tray 350 can be selected based on frequency of service or maintenance needed by a particular system. For example, the lines requiring more frequent service can be located on a higher level within the plumbing tray 350 to provide easy access to operators.

Figure 9 is a side view of a facility interface 510 of a mainframe plumbing tray 350. The facility interface 510 is disposed on the end of the system below the load lock chambers. The facility interface 510 may include a panel for mounting various connections. Alternatively, the facility interface can be positioned at any location on the system which can provide access to the factory facility connections. The facility interface provides a single location at which the factory facility are connected to the system. The layout of the facility connections on the facility interface reflects the tiered structure of the conduits disposed in the plumbing tray 350. The facility interface is disposed on the mainframe and connected to the plumbing tray 350 to provide a fixed configuration for the facility connections from the factory to the distributed positions on the system. The fabrication facility can be constructed with a common connection interface so that the system can be moved into the fabrication facility and connected to the facility interface without the need to run multiple lines or conduits. The facility interface is preferably located in the same location on each to tool to standardize the installation and maintenance of each system. The facility interface shown in Figure 9 includes a pair of pneumatic control and exhaust connections 902, 904, gas supply lines shown collectively at 906, cooling water supply connections 908, 910, helium supply and return 912, blowout air 914 and pneumatic control 916, de-ionized water supply 918, nitrogen purge 920, system vacuum 922, and system exhaust 924.

Facility interface 510 also includes the electrical and electronic interface between the process chambers and controller 410 and AC loadcenter 440. Facility interface 510 provides a common connection or interface point on the system for distribution thereafter to each of the chamber interfaces in furtherance of the modular aspects of the processing system. DC power connection 952 provides +15 v, -15 v and 24 v DC power to the chambers. Leak and smoke detection sensors within the mainframe are coupled to detector port 954. Emergency off or EMO signals are provided via EMO connections 950. Interlock signals are communicated via interlock connection ports 956 to the interlock PCB contained within the chamber tray electronics enclosure 382 (shown in Figures 11A, 11B).

Figure 10 is a side view of the mainframe plumbing tray 350 illustrating three chamber interfaces 500, including a centrally located transfer chamber interface. The facility connection via the chamber interfaces can be identical for each chamber position and the load locks and transfer chamber. For example. the process line connection point, the He connection point, and the vacuum connection point can be located in the same position at each chamber position to enable reconfiguration of a system or removal and replacement of chambers on the system. A chamber interface may include electronics connections 926 on the upper end of the interface; process gas connections 928 therebelow; helium supply 930 and return 932 and blowout air 934 and pneumatic control 936 therebelow; air exhaust 938, system vacuum 940 and de-ionized water connections 942 on the lower portion of the interface. Electronics connections 926 include EMO connection 970, DC power 972 and interlock PCB 974. It is to be appreciated that electronics connections 926 represent the intermediate connection point between the electronic and electrical connections in facility interface 510 and the appropriate electrical and electronic components located in chamber trays 380. For example, the interlock PCB located inside chamber tray electronics enclosure 382 is connected to chamber interface interlock connection 974.

Figures 11A and 11B are isometric views of a chamber tray 380. A chamber tray is connected at the chamber interface to the mainframe, typically below the process chamber with which it is associated. The chamber tray 380 includes a support frame 1100 on which the necessary facility control devices can be located. Adjustable legs 1101 are provided to properly position the chamber tray adjacent the mainframe. The chamber and the chamber tray can be mounted on a support frame supported on casters or other suitable rollable support members thereby further facilitating the modular aspects and interchangeability of each of the chambers with regard to their position on the main frame. The chamber tray includes connections to which each of the connections on the chamber interface can be connected. The chamber tray can be configured to connect to a common chamber interface and distribute the facility in a manner compatible with the particular process chamber. In the embodiment described herein, the chamber trays are identically configured to provide ease of manufacture, installation and maintenance.

The chamber tray 380 can include an electronics box 382 with chamber control cards (not shown) disposed therein, a device net hub 1102, chamber vacuum port 1104, chamber pneumatic distribution manifold 1106, individual pneumatic control valves 1108, a gas panel 1110 that includes mass flow controllers (MFC) 1112 and shut-off valves 1114. The electronics box 382 is positioned on the front of the chamber tray opposite the connection between the chamber tray and the mainframe. The MFC connections are located inwardly of the electronics. Two MFCs 1112 are shown, however, depending on process chamber type or processing operations conducted within the processing chamber, additional lines may also be plumbed and may include additional MFCs. Alternatively, the MFCs, the pneumatics and the electronics can be arranged in any configuration suitable for connection to the chambers positioned adjacent the chamber tray. Preferably, the electronics are positioned outwardly of the mainframe to protect the electronics from any potential fluid leaks on the mainframe. By including all the facility and control in a chamber tray, the connections between the chamber and the chamber tray are standardized in the same way the connection points between the main frame plumbing tray and facility connections to the chamber tray are standardized. Through this standardization, a modular system having interchangeable chamber positions can be provided and reconfigured with little regard to the connections that are needed since the connection points at each position on the main frame are similar and the parts are interchangeable.

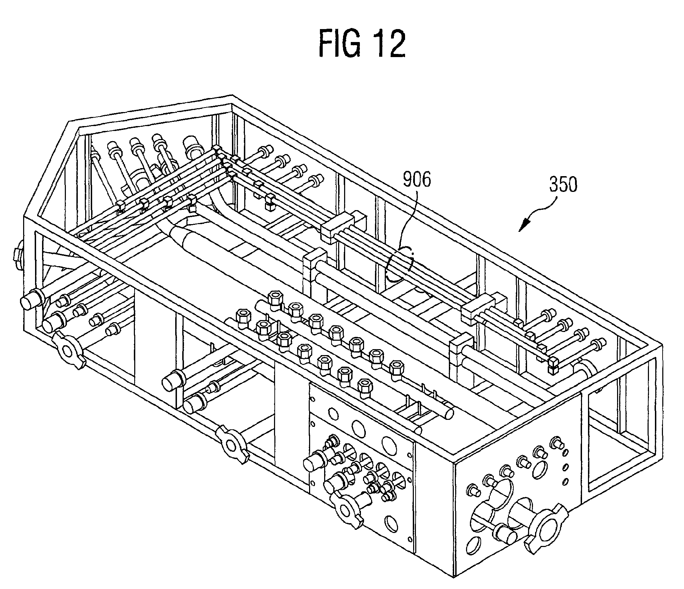

Figures 12-15 show each of the layered aspects of the process gas lines, helium supply and return, system exhaust manifold and water manifold. Figure 12 is a substantially top perspective view of the gas lines positioned in the upper portion of the plumbing tray. The gas lines are distributed in a U-shaped configuration with connections disposed at each chamber interface including the process chamber interfaces, the load lock interfaces and the transfer chamber interface. The gas lines include break points or disconnect points at a common location along their length. The break points are located to provide easy access for removal, replacement or maintenance.

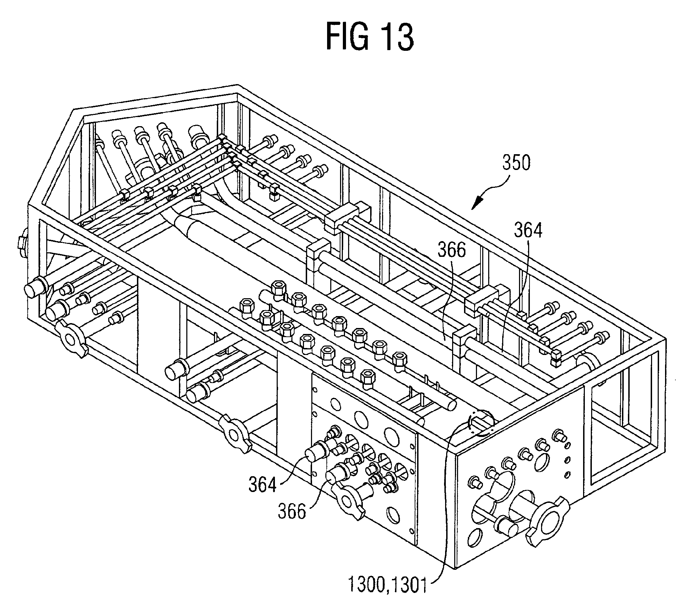

Figure 13 is an isolated view of the liquid helium manifold having supply and return lines 364, 366 that is distribute helium for cooling the cryo-pumps on the system. Much like the other manifolds, the helium manifold is a U-shaped configuration with break points 1300, 1301 to allow ease of removal for maintenance and service. The break points may be conveniently located to prevent access interference between break points of adjacent lines.

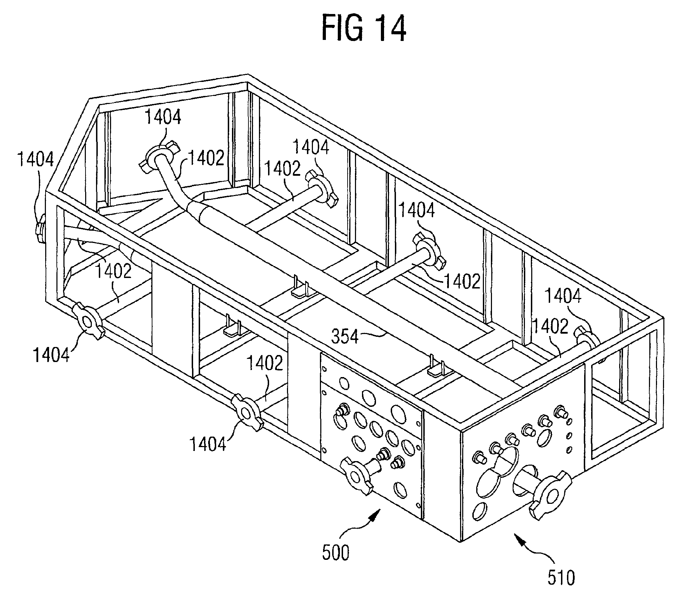

Figure 14 is an isometric view of a vacuum manifold 354. The vacuum manifold is disposed in a U-shaped configuration with a break point 1400 (not shown) proximate the facility interface 510. The vacuum is distributed to each one of the chambers via conduits 1402 which include universal connections 1404 for each of the chambers regardless of chamber position.

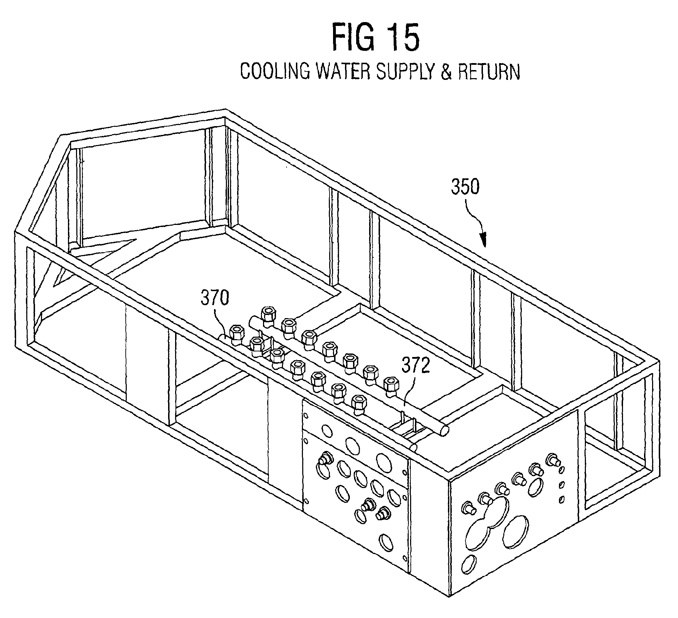

Figure 15 shows the water manifold 370 and system exhaust manifold 372 disposed on the bottom in the center of the main frame plumbing tray. Preferably, the water manifold 370 is disposed in the lowest position in the plumbing tray to minimize the effects of a leak. One or more sensors can be located in the facility tray to detect moisture or volatile gases, if applicable. Flexible hose or conduits can be connected between each of the connection points illustrated on the water manifold and the exhaust manifold to the connection points on each chamber interface and thence to each of the chambers. Water detection circuitry or leak detection circuitry can be laid along the bottom of the main frame to provide early warning of any problems with the water manifold.

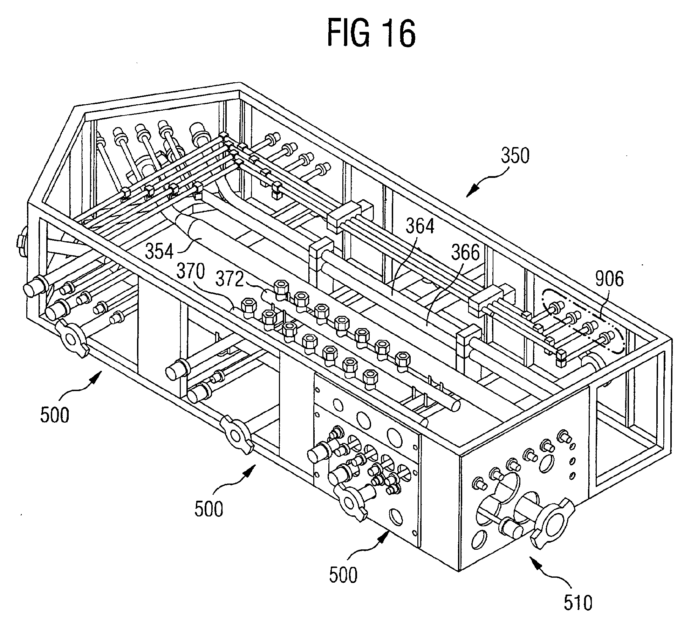

Figure 16 is an isometric view of a plumbing tray 350 showing the layout of the process lines 406, the liquid helium supply 364 and return 366, the system exhaust manifold 372 and the water manifold 370. The relationship between each of the systems and the access therebetween is shown. Also shown is the uniform presentation of the connections to each of the chamber trays.

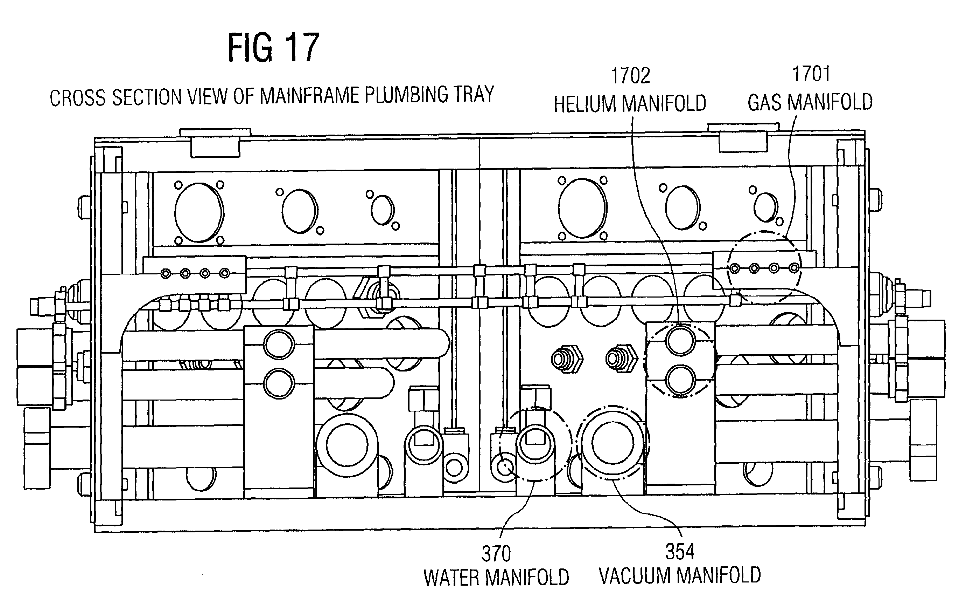

Figure 17 is a cross-sectional view of the main frame plumbing tray 350 illustrating the V-shape of the various plumbing lines that are provided in the main frame plumbing tray. The V-shape provides easy access and ease of removal of each of the lines. The V shape provides an empty center region within the main frame in which technicians can work. As detailed above, the process gases of a gas manifold 1701 are shown in the highest envelope. Liquid helium lines of a helium manifold 1702 are disposed in the next level down. The system vacuum manifold 354 and the water manifold 370 are located in the lowest envelope in the plumbing tray. The plumbing lines in the highest level are located radially outward from the center and converge in each envelope to a central location in the lowest envelope.

Other layouts or configurations are feasible such as a configuration where the system exhaust is on top and the helium supply and return are on the bottom, etc. However, the arrangement described with reference to the figures is believed to be advantageous because the lines that are serviced more frequently, *e.g.*, the process lines. are located on the top where access is convenient. The lines that cause the most problems and are most likely to leak and cause damage, such as the water manifold, are positioned on the bottom. In such a case, water manifold leaks are contained by the drip pan located in the bottom most part of the mainframe plumbing tray. Thus, fluids released by the leak are less likely to damage adjacent lines or components. Vacuum and helium are interchangeable, but the vacuum manifold is difficult to test and leak check so it has been positioned in the upper portion of the plumbing tray. The streamlined arrangement or simplicity provided by this plumbing arrangement makes leak detection, maintenance and repair of each of these connections easier. For example, if a vacuum problem develops during operation of the system, a technician can easily access each vacuum line connection thereby simplifying isolation of the problem to a particular chamber position or fitting. The streamlined piping layout of the present invention provides increased accessibility to vacuum line connections, process line connections, and the liquid helium connections. In contrast, access to facility connection points in conventional processing systems is difficult and typically requires a great amount of disassembly of adjacent plumbing lines or structures to gain access to these connection points.

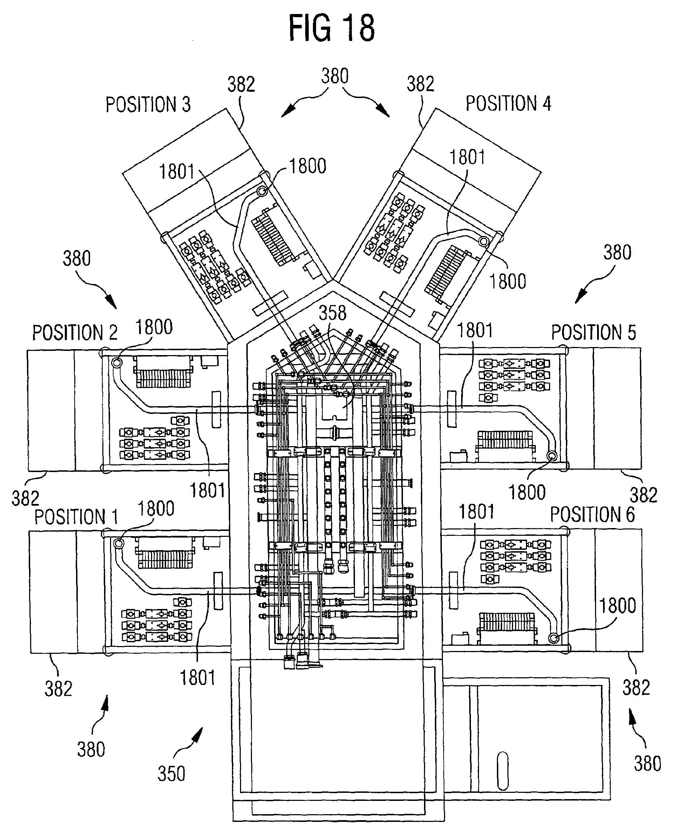

Figure 18 is a top view showing each of the chamber trays 380 positioned adjacent the mainframe plumbing tray 350. The connection of the vacuum line 1801 from the vacuum connection on the mainframe plumbing tray 350 to the vacuum drop on the chamber tray 380 is shown. Note that each vacuum connection line attached to each chamber interface is identical and that the vacuum connection port 1800 is positioned in the same position within each chamber tray so that each chamber is connected to a vacuum port in the same relative position. Chamber 6 illustrates a line connection for process gas being connected to two MFC modules 1112 inside the chamber 6 chamber tray. Also shown are the various air control valves within the pneumatic manifold. The chamber electronics contained within the chamber tray electronics box 382 are obscured by a cover positioned on the electronics portion of the chamber tray.

Also illustrated in Figure 18 is the mainframe pneumatic distribution block 358. From this central pneumatic distribution point, pneumatic supply is distributed to each of the chamber interfaces and thence to each chamber tray pneumatic distribution block with flexible polyurethane line (not shown). Control air is supplied from a central mainframe distribution point out to the chamber trays 380. The individual pneumatic control valves for the pneumatically controlled components are located in the pneumatic control blocks within each of the chamber trays. This distributed supply of pneumatic control simplifies troubleshooting and maintenance of the pneumatic system on each chamber since the individual pneumatic devices of each chamber are readily identified at each chamber pneumatic block. Examples of pneumatically operated chamber equipment and devices include the heater lift, the wafer lift. the wafer shutter used to cover a wafer during titanium nitride processing, and MFC shut off valves. Additionally, a pneumatically actuated gate valve is typically provided to isolate the cryo-pump from the chamber processing volume during vacuum pump operation, and a pneumatically actuated vacuum isolation valve is provided that isolates the roughing pump from the chamber processing volume and the cryo-pump whenever roughing pump operation is not required.

Another advantage of the modular processing system of the present invention is overall simplicity in manufacturing the system. Assembly procedures for conventional processing systems usually involve serially assembling one set of components, testing those components and then assembling and testing the next set of components, and so on until all components have been assembled and tested. Integration of the individual components does not occur until each individual set of components has been assembled and tested, thereby increasing manufacturing time. In contrast, the modular design of a system according to the invention allows separate portions of the system to be assembled and tested in parallel. For example, the mainframe, transfer chamber, process chambers, mainframe plumbing tray and chamber trays may each be assembled and tested individually. After testing, integration of the separate modules is simple - the mainframe plumbing tray is inserted into the mainframe; the chamber trays are attached to the mainframe; the transfer chamber is attached to the mainframe and the individual process chamber are attached to the monolith. Finally, the connections are made between each chamber interface and its respective chamber tray and between each chamber tray and its respective chamber.

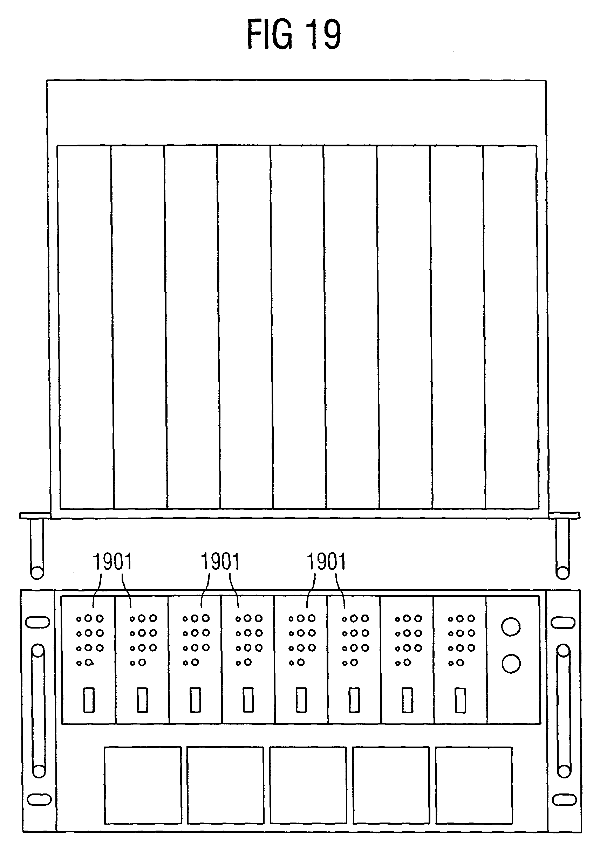

Figure 19 is a view of the modular DC power supply of the present invention. The DC power in a processing system according to the present invention is distributed to each of the chambers. Accordingly, the DC power supplies 1901 of each chamber board are sized to accommodate the various 24 volt, and positive and negative 15 volt DC loads of an individual chamber 321-326 (shown in Figure 4A). Accordingly, when a system is manufactured, it need only have sufficient DC power for main frame power loads and remote power loads as illustrated in the figure. The DC power for each individual chamber load is individually supplied as those particular chambers are added on to the system. In this way, DC power is conserved and the cost of the system is reduced. Modularity of the processing system enables chambers to be added or moved to and from different positions with the DC power supply for that particular chamber being moved to a different position in the card cage for the modular DC power supply. The modular DC power supply is located on the system controller rack as illustrated in Figure 3 in phantom in remote systems 400.

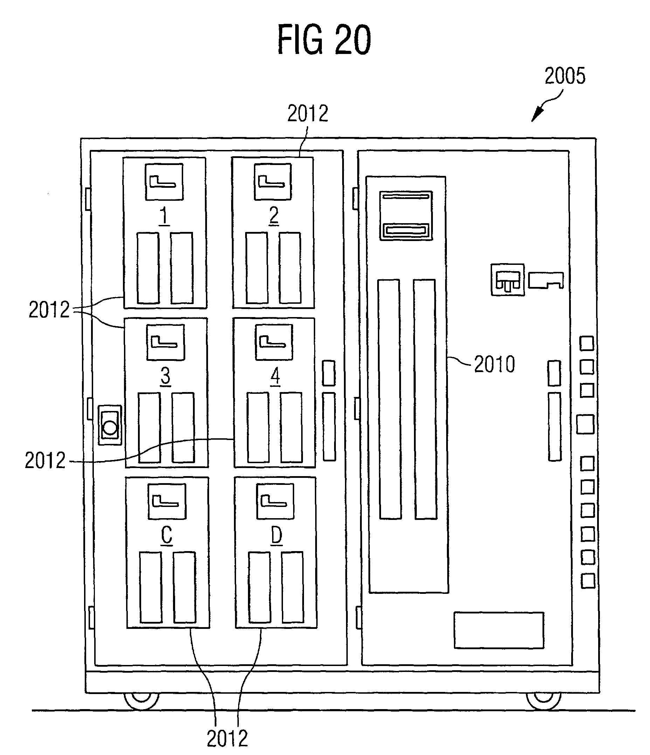

Figure 20 illustrates a modular AC load center 2005 of the processing system. The modular AC load center 2005 includes breakers distribution conduits and other support circuitry for all mainframe and remote system electrical loads located within the main distributor panel 2010. These general AC loads are preferably located in one panel such as main distribution panel 2010. Main distribution panel 2010 includes non chamber specific electrical loads such as the cryo compressor, heat exchanger, lid lift, system vacuum and the equipment rack fans. The modular design of the processing system of the present invention continues on into the AC load center 2005 design where each individual chamber 321-326 is provided with its own set of circuit breakers, distribution conduits and other support circuitry for all chamber specific electrical loads. Individual chamber electrical distribution boxes 2012 are dedicated to each of the six chamber positions 321-326. Because all of circuit breakers, distribution conduits and other support circuitry for a chamber is contained in a single distribution box 2012, electrical power can be added to or removed from a particular chamber in a particular chamber position by simply adding or removing a distribution boxy 2012 from the corresponding chamber breaker box position on AC load center 2005. Examples of individual chamber electrical loads include: servo motor drivers, heater drivers, DC RF power supplies, turbo pump controllers, vacuum pumps (*e.g.*, for a pre-clean chamber) and the cryo-pump regeneration heater.

This modular design approach of AC load center 2005 provides at least two advantages. One advantage is that only breaker boxes 2012 that are needed are installed. The modular chamber breaker box 2012 allows a processing system with only 3 chambers to be outfitted with three chamber breaker boxes 2012 - one each of the three chambers. The other three vacant or available chamber positions could be blanked off for future use should additional chambers be added or existing chambers moved into one of the previously unoccupied positions. In this way, electrical distribution is provided as needed instead of providing chamber breaker boxes 2012 for all six chambers regardless of whether six chambers or three chambers are installed on the system.

Another advantage of the modular design of the AC load center is in the area of electrical safety. In conventional systems, electrical power to a specific chamber may be located in several different locations and requires access to both clean room and non-clean room spaces to cut-off electrical power. If any electrical load is not completely isolated, a technician servicing a chamber or other system component may be harmed. The modular design that includes chamber distribution boxes 2012 removes the necessity to cut off power in several locations by providing all chamber electrical isolation at one point. This modular AC power distribution permits localized lock out tag out (LOTO) on a per chamber basis or on a per remote component basis for module level and system level servicing and maintenance.

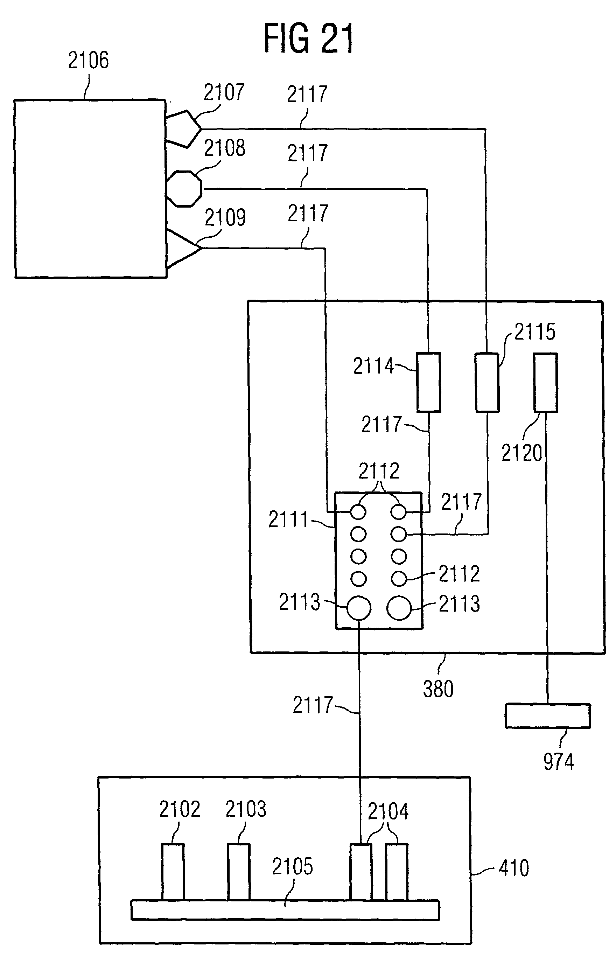

Figure 21 is a schematic view of a system controller 410, a representative processing chamber 2106 and chamber tray 380 which illustrates a conventional device net communication configuration. Unlike conventional systems where chamber control PCBs are centrally located, chamber control PCBs (2114, 2115, and 2120) on the inventive system are provided in the electronics enclosure 382 of each chamber tray 380. System controller 410 includes a single board computer 2102, mass storage device 2103 and device net scanners 2104 connected to and in communication with each other via a back plane 2105. Single board computer 2102 provides the processing power for operation of semiconductor processing system 200 and includes a processor, random access memory and other well known electronic circuitry. Mass storage device 2103 provides data storage capacity for single board computer 2102 and includes a hard drive and a floppy drive, or other storage capability. Device net scanner cards 2104 receive information from and provide information to the various device net components and hubs located throughout processing system 200. The device net scanner card 2104 receives the various device net signals from the chambers and other system components (otherwise known as device net nodes) and provides them to the system controller 410. Next, using lookup tables, stored information, or other suitable interpretation methods, the system controller 410 translates and interprets the incoming data into suitable communications signals useable by the software and programs executed by the system controller 410. Figure 21 illustrates one such connection where a scanner card 2104 is connected via a cable 2117 to a trunk connection 2113 on device net hub 2111 located in a chamber tray 380.

Communication between system controller 410 and the components of processing system 200 will now be described with regard to a representative processing chamber 2106. Process conditions and operational status of processing chamber 2106 are monitored and controlled by a variety of devices which will be considered as one of three device types depending upon the information format the device provides.

The first type of devices are device net ready devices. Component 2109 represents a device net device in communication with chamber 2106. Device net ready device 2109 provides information to and receives information from system controller 410 in the device net protocol. As such. information provided to or received from device net ready device 2109 may be sent directly to the system controller 410 without further translation. Referring to Figure 21, device net ready component 2109 is connected to a node 2112 on device net hub 2111 via suitable electrical cable 2117. Within device net hub 2111, node 2112 is coupled to trunk connection 2113 and trunk connection 2113 is coupled to system controller 410 via a suitable cable 2117 connected to device net scanner card 2104. In an example where processing chamber 2106 is a representative physical vapor deposition chamber, examples of device net ready devices include an ion/convectron pressure gauge controller, heater pedestal lift motor driver and pneumatic distribution solenoid block.

The second type of device is an analog device. Component 2107 represents a device that produces an analog signal in response to conditions within chamber 2106. The analog signals produced by analog device 2107 are provided to analog input/output board 2115 located within electronic enclosure 382 in chamber tray 380. The analog signal produced by the analog device 2107 is then translated into the device net signal protocol. The output of analog input/output board 2115 (*i.e.,* a signal in the device net protocol ) is coupled to a device net node 2112 on device net chamber hub 2111 via suitable electronic cable 2117. Within device net hub 2111, node 2112 is coupled to trunk connection 2113 and trunk connection 2113 is coupled to system controller 410 via a cable 2117 connected to device net scanner 2104. Signals from system controller 410 to analog component 2107 follow the same electronic pathway except that analog input/output board 2115 operates to translate the device net signal from the system controller into an analog signal for use with component 2107. In an example where processing chamber 2106 is a representative physical vapor deposition chamber, analog devices include, for example, a baratron, a mass flow controller, and a RF match set-point controller.

The third type of device is a digital device. Component 2108 represents a device that produces a digital signal. The digital signals produced by digital device 2108 are provided to digital input/output board 2114 located within chamber electronics enclosure 382 in chamber tray 380. The digital signal produced by the digital device 2107 is then translated into a device net signal. The output of digital input/output board 2115 (*i.e.,* a signal in device net protocol) is coupled to a device net node 2112 on device net chamber hub 2111. Within device net hub 2111, node 2112 is coupled to trunk connection 2113 and trunk connection 2113 is coupled to system controller 410 via a cable 2117 connected to device net scanner card 2104. Signals from system controller 410 to digital component 2108 follow the same electronic pathway except that digital input/output board 2114 operates to translate the device net signal from the system controller into a digital signal for use with digital component 2108. In an example where processing chamber 2106 is a representative physical vapor deposition chamber, digital components include. for example, as slit valve open/close indicator; a heater lift position sensor; a water flow indicator; a gate valve open sensor and a chamber lid switch.

As described above, each chamber electronics enclosure 382 may include digital input/output boards 2114 and an analog input/output board 2115. Additionally, each chamber electronics enclosure 382 may include a chamber interlock board 2120. The chamber interlock board 2120 is used to provide hardware interlocks that stop certain functions on the system to prevent personnel injuries or severe equipment damage. For example, interlock circuitry is used to prevent the operation of high voltage DC power when the chamber lid is open.

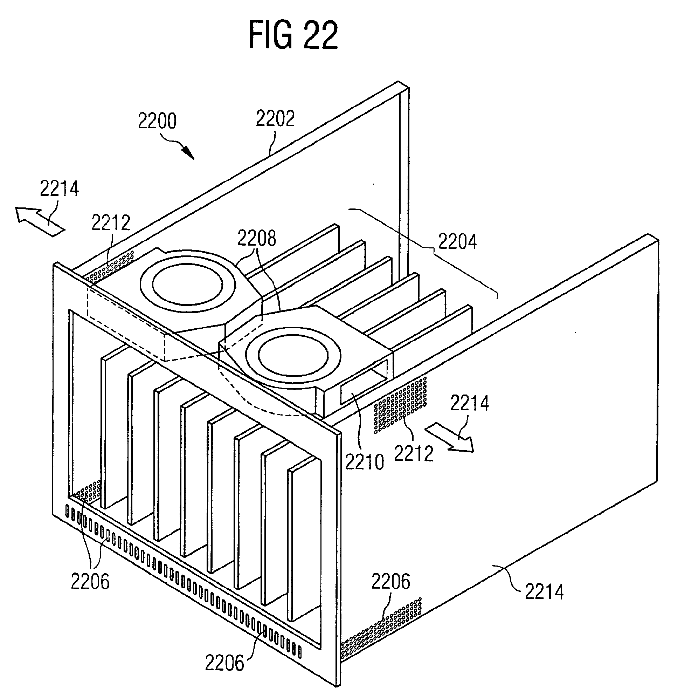

Figure 22 is an isometric view of a reduced vertical height cooling system 2200 of the invention. Illustrated is a conventional card cage 2202 having a plurality of printed circuit boards 2204 arranged within an electronics panel. Cooling fluid, such as air, is provided between and among the printed circuit boards through inlets 2206 located on the bottom of the card cage. Cooling fans 2208 are located adjacent the PCBs 2204 in the top of the card cage. The cooling fans have inlets adjacent to the face of the printed circuit boards. The fans include outlets 2210 which discharge air orthogonally to the inlets. As a result, a plurality of card cages can be stacked since the cooling fan outlets 2210 do not require additional vertical space to provide sufficient cooling. The discharge from outlet 2210 flows through vents 2214 in card cage 2202. A plurality of electronics housings may then be stacked closely together in a vertical plane or the vertical space between them can be reduced since cooling air does not circulate between the top portion of the housing, but is instead discharged through the sides.

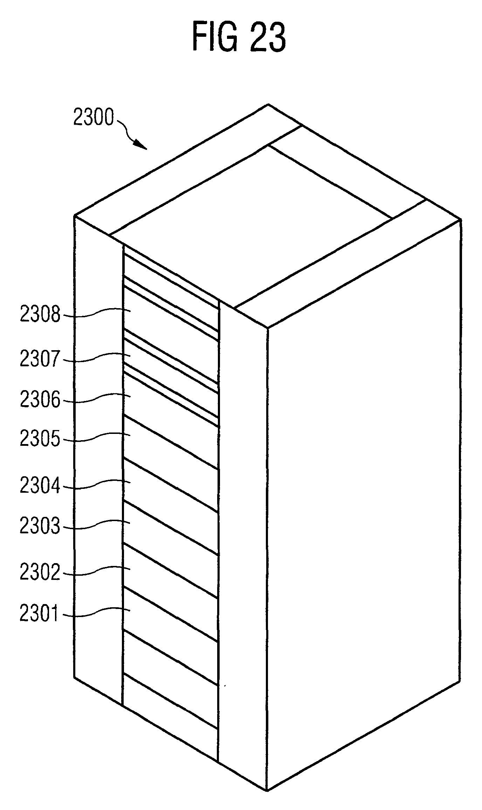

Figure 23 is an isometric view of a modular equipment rack 2300 of the present invention. The modular equipment rack 2300 is configured to provide electrical power and cooling water, if needed, to the remote chamber components such as RF generators, target bias power supplies and heater drivers. As initially constructed, the modular equipment rack 2300 support trays or slot positions for up to 8, 4U size electrical components (i.e. 4U size components are about 7" high). These 8 slot positions are indicated as 2301-2308. Each of the individual slot positions 2301-2308 are provided with electrical contacts, circuit breakers and electrical conduits to support an electrical component. Such a modular design allows for system expansion by providing robust electrical connectivity and distribution design such that additional components are added easily to the existing electrical distribution frame work.

In a representative system 200, two modular equipment racks 2300 may be provided. One rack 2300 may be used to support, for example, the DC power supplies used for plasma operations in PVD chambers; the RF power supplies for plasma operation in a pre-clean or in same CVD (chemical vapor deposition) chambers and turbo pump controllers for chambers that employ turbo pumps such as, for example, tungsten CVD, CVD titanium and CVD aluminum. Another modular equipment rack 2300 may be used to provide electrical connectivity and distribution, for example, to heater drivers for resistive heaters used to heat transfer chamber 302, and lamp drivers used to control power to lays modules in the single substrate loadlocks. The manufacturing and safety advantages described above with respect to modular AC load center 2005 (shown in Figure 20) are also found in modular equipment rack 23.

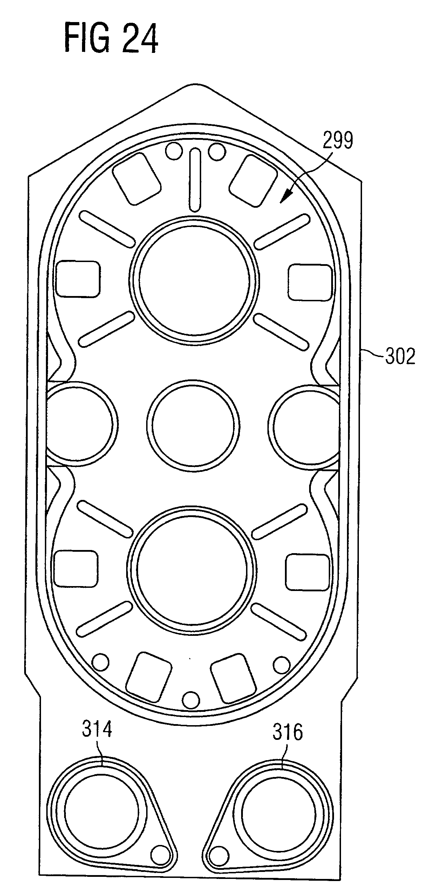

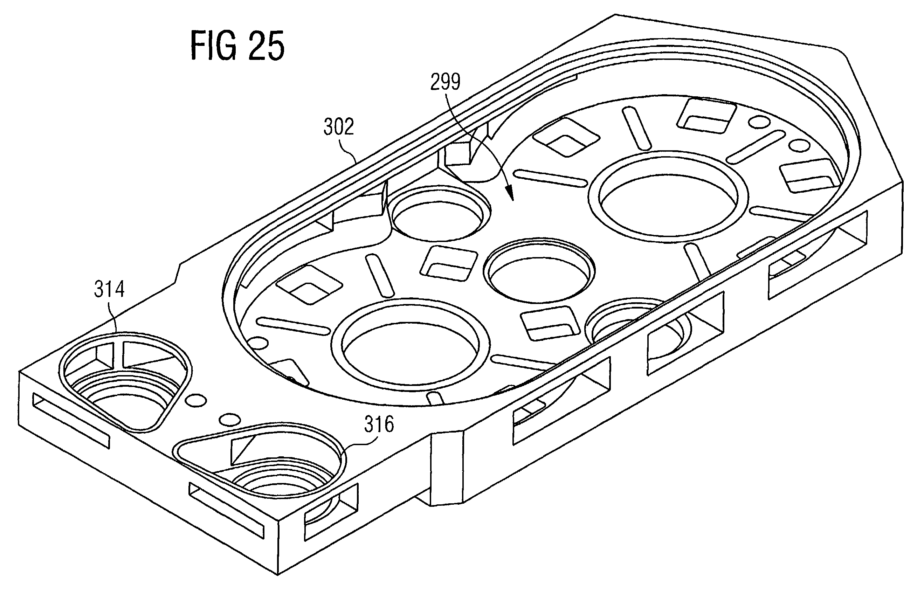

Figures 24 and 25 are isometric views of an alternative embodiment of a monolith 302 defining both a transfer volume 299 and two single wafer load locks 314, 316. The monolith 302 is formed from a single block of aluminum. One advantage of the integrated monolith is that sealing surfaces between the two single substrate load locks are eliminated thereby reducing the additional vacuum sealing requirements of mounting individual single substrate load lock onto the transfer chamber 302 as illustrated in Figure 2. In addition to having a unitary monolith, the transfer chamber and/or the load locks could be formed from a support frame having skins sealably mounted thereto.

### Processing Sequences and Methods

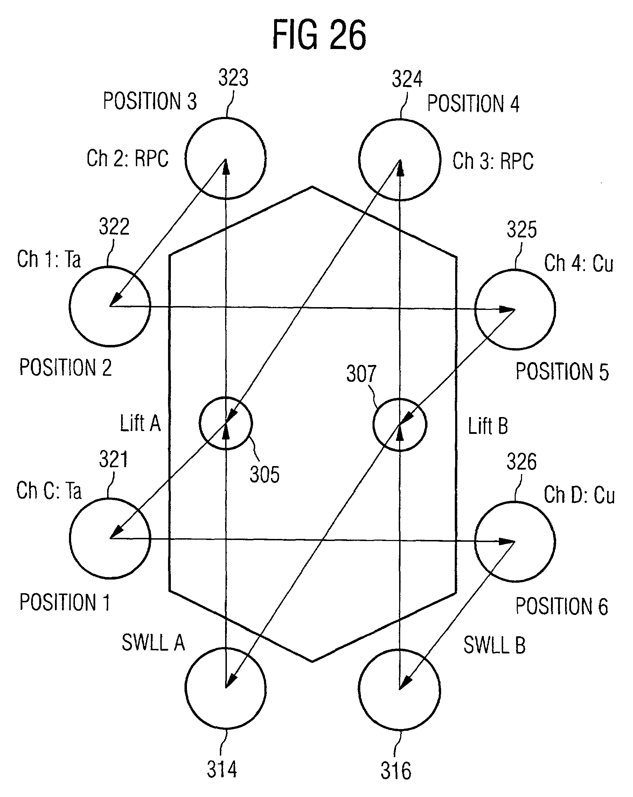

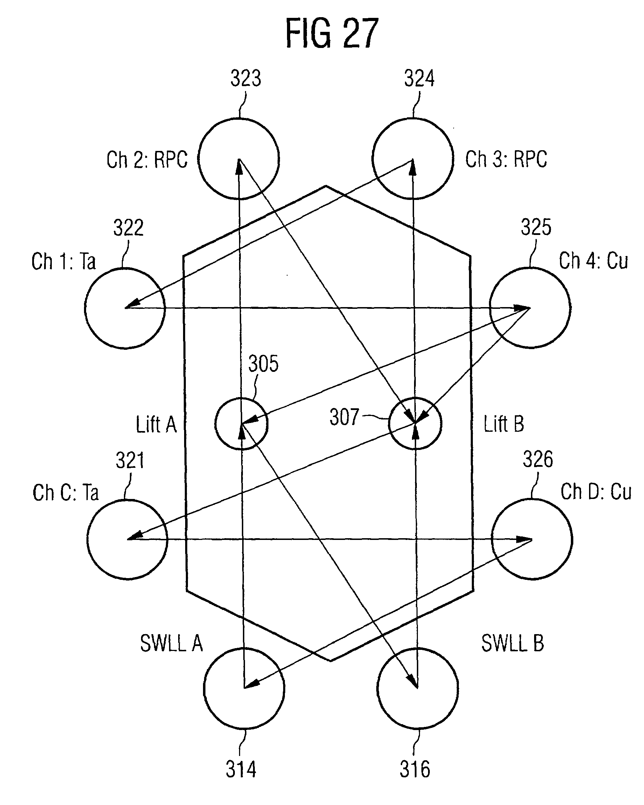

Processing system 200 can be utilized to perform a variety of processing sequences. Figures 26 and 27 are schematic views illustrating two parallel processing sequences of the invention. In these parallel processing sequences, robots 311 and 313 operate in tandem to transfer a pair of substrates through the various processing positions so that in at least two of the processing steps, the pair of substrates are processed simultaneously or nearly simultaneously. In these processing sequences, the chambers in positions 3 and 4 are the same type of chamber, the chambers located in positions 1 and 2 are the same type of chamber, and the chambers located in positions 5 and 6 are the same type of chamber. For example, chambers 323 and 324 located in positions 3 and 4 could be pre-clean chambers. In a pre-clean chamber, a non-selective plasma etch process is performed to remove native oxides from the surface of and features formed on the wafer being processed. A variety of pre-clean processes may be utilized. The pre-clean process may employ a plasma formed from, for example, Argon, or, a mixture of helium and hydrogen, or an argon plasma followed by a hydrogen reduction process. Chambers 321 and 322 located in positions 1 and 2 could be chambers suitable for depositing a seed or barrier layer. For example, chamber 321 and 322 could be physical vapor deposition (PVD) chambers that utilize an inductive coil in conjunction with a DC magnetron sputter deposition method to deposit suitable seed layers or barrier layers, such as tantalum and/or tantalum nitride, in order to improve the adhesion and conformity of the subsequent metal layer deposition. An example of this type of chamber is the Ionized Metal Plasma PVD chamber available from Applied Materials, Inc. of Santa Clara, California. Chambers 325 and 326 located in positions 5 and 6 could be chambers suitable for depositing a metal layer. For example, chamber 321 and 322 could be physical vapor deposition chambers that utilize DC magnetron sputter deposition methods to deposit a desired metal layer. Representative materials deposited during metallization include, for example, aluminum, tungsten, and copper. Two suitable deposition sequences include, for example: (1) a pre-clean process, followed by the deposition of a tantalum or tantalum nitride barrier layer or seed layer followed by the deposition of a copper layer, or (2) a pre-clean process, followed by the deposition of a titanium or titanium nitride barrier layer or seed layer, followed by the deposition of an aluminum layer. Other configurations and processing sequences could also be performed.

A representative parallel processing sequence will now be described with reference to Figure 26. Atmospheric robot 206 moves along slidable position 208 to a position adjacent to the storage cassette 220 which has the wafers to be processed. Using movable blades 212 and 214, wafers 1 and 2 are removed from the appropriate cassette 220 and placed on the blades 212 and 214, respectively. Atmospheric robot 206 then moves along slidable position 208 to a position adjacent to atmospheric orienter station 216. Wafer 1 is then loaded onto atmospheric orienter station 216 and oriented. Wafer 1 is then returned to blade 212 and wafer 2 is placed on wafer orienter 216. While wafer 2 is being oriented, atmospheric robot 206 moves along slidable position 208 to a position adjacent to single substrate load lock 316. Wafer 1 is loaded into single substrate load lock 316. Wafer 1 is then pre-heated and degassed as single substrate load lock 314 transitions from atmosphere to transfer vacuum. Atmospheric robot 206 then moves along slidable position 208 to transfer wafer 2 from atmospheric orienter 216 to single substrate load lock 314. After loading wafer 2 into single substrate load lock 314, atmospheric robot 206 returns to cassette 220 and places wafers 3 and 4 on blades 212 and 214 respectively. Wafers 3 and 4 are then oriented and transferred into single substrate load locks 316 and 314, respectively, and are pre-heated and degassed as described above with regard to wafers 1 and 2.

Wafer 1 is transferred from single substrate load lock 316 onto primary blade 301 of robot 311 and placed on lift 307. Lift 307 rotates so that wafer 1 is accessible with the proper orientation to robot 313. Wafer 1 is then removed from lift 307 by either of the blades 309 or 315 on robot 313 and transferred into the pre-clean chamber 324 in position 4. Wafer 1 is then processed in chamber 324 according to a suitable pre-clean recipe. After placing wafer 1 on lift 307 robot 311 removes wafer 2 from single substrate load lock 314 and places wafer 2 on lift 305. Lift 305 then rotates to place wafer 2 in a consistent orientation with respect to robot 313. Robot 313, using either of the blades 309 or 315, then transfers wafer 2 from lift 305 into chamber 323 at position 3. Wafer 2 is then processed in chamber 323 according to a suitable pre-clean recipe.

Robot 311 then transfers wafer 3 from load lock 316 to lift 307 and wafer 4 from load lock 314 to lift 305. Wafer 3 is then rotated on lift 307 and placed on auxiliary blade 315 of robot 313. Once wafer 1 has completed the pre-clean process in chamber 324, robot 313 removes wafer 1 with primary blade 309, rotates and places wafer 3 into chamber 324 and then places wafer 1 on lift 305. The pre-clean process on wafer 3 begins. Robot 313 then removes wafer 4 from lift 305 with auxiliary blade 315 and, once wafer 2 has completed the pre-clean process in chamber 323, removes wafer 2 with primary blade 309, places wafer 4 in chamber 323 and places wafer 2 in chamber 322. At about the same time robot 311 has removed wafer 1 from lift 305 and places wafer 1 into chamber 321 at about the same time as wafer 2 is placed in chamber 322. Wafers 1 and 2 are processed in chambers 321 and 322 according to an appropriate seed layer recipe.

While the above transfers are being conducted, wafers 5 and 6 have been oriented and transferred into single substrate load locks 316 and 314, respectively. Wafers 5 and 6 arc pre-heated, degassed and transferred via robot 311 onto lifts 307 and 305, respectively. When wafers 1 and 2 have completed processing in chambers 321 and 322, wafer 1 is transferred via robot 311 from the chamber 321 into chamber 326. At about the same time, wafer 2 is transferred via robot 313 from chamber 322 into chamber 325. Wafers 1 and 2 are then processed in chambers 326 and 325, respectively, simultaneously or nearly simultaneously according to a suitable metal deposition process.

After wafer 3 has been processed in chamber 324, robot 313 transfers wafer 3 from chamber 324 to lift 305 while transferring wafer 5 from lift 307 into chamber 324. Wafer 5 is then processed in chamber 324 according to a suitable pre-clean recipe. After wafer 4 has been processed in chamber 323, robot 313 transfers wafer 6 from lift 305 to chamber 323 and wafer 4 from chamber 323 into chamber 322. Wafer 6 is then processed according to a suitable pre-clean recipe. As robot 313 is placing wafer 4 in chamber 322, robot 313 removes wafer 3 from lift 305 and places wafer 3 in chamber 321. Wafers 3 and 4 are processed simultaneously or nearly simultaneously in chambers 321 and 322, respectively, according to a suitable seed or barrier layer process.

While the above transfers are being conducted, wafers 7 and 8 are oriented and transferred into single substrate load locks 316 and 314, respectively. Wafers 7 and 8 are then pre-heated and degassed. When wafer 2 completes processing in chamber 325, robot 313 removes wafer 2 from chamber 325 and places wafer 2 on lift 307. With auxiliary blade 303, robot 311 removes wafer 7 from single substrate load lock 316 and with primary blade 301 removes wafer 2 from lift 305. Robot 311 then places wafer 2 into single substrate load lock 314 and wafer 7 onto lift 305. Next, robot 311 transfers wafer 8 from the single substrate load lock 314 to lift 305 and transfers wafer 1 from chamber 326 to single substrate load lock 316. When wafers 2 and 1 are placed into a single substrate load locks 314 and 316, respectively, the wafers are cooled down via the temperature controlled substrate support located within the load locks while the load locks vent to atmosphere. Once the load locks have been vented, atmosphere robot 206 then transfers wafers 1 and 2 from the load locks 314 and 316 into a storage cassette 220.

While the above transfers are being conducted, wafers 3 and 4 have completed processing in chambers 322 and 321. As described above with regard to wafers 1 and 2, wafers 3 and 4 our transferred into chambers 325 and 326 and processed nearly simultaneously. Next, as described above with regard to wafers 1 and 2 and 3 and 4, wafer 7 is placed in chamber 324 and wafer 5 is placed on lift 305. Wafer 8 is placed in chamber 323 and wafer 6 is placed in chamber 322. Wafer 5 is placed in chamber 321 so that processing of wafers 5 and 6 occurs simultaneously or nearly simultaneously. Using the above described sequencing, pairs of wafers can be moved through a processing system 200 having three processing sequences (i.e., pre-clean, seed layer deposition and metal layer deposition) such that at least two of the processing sequences are conducted simultaneously or nearly simultaneously on a pair of wafers. One advantage of conducting simultaneously nearly simultaneous processing is that equipment may be shared between the processing chambers thereby providing a cost savings. For example, chambers 321 and 322 when utilized according to the parallel processing sequence described above, may share common gas supplies, mass flow controllers and vacuum pumps.

The parallel process sequence described above is merely illustrative of numerous transfer pathways that may be implemented on a system of the invention. For example, wafers could be transferred into chambers 323 and 324 first and then followed by processing in chambers 325 and 326. Wafers would be processed in chambers 321 and 322 before exiting the system via single substrate load locks 314 and 316. Although the throughput of wafers through processing system 200 would be diminished, robot 313 and 311 could be of the type having only a single blade instead of the dual blade robots illustrated in Figure 4A. Processing chambers 321 through 326 could also be selected to perform specific metallization sequences. For example, in a copper deposition sequence, chambers 323 and 324 are pre-clean chambers, chambers 322 and 321 are chambers suitable for the deposition of a tantalum or tantalum nitride seed layer and chambers 325 and 326 are suitable for the deposition of a copper layer. In another example where processing system 200 is used for aluminum deposition, processing chambers 323 and 324 are again pre-clean chambers. Chambers 322 and 321 are suitable for the deposition of a titanium or titanium nitride seed layer. Chambers 325 and 326 are chambers suitable for the deposition of aluminum.

Another example of a process sequence is shown schematically in Figure 27. In Figure 27, a wafer 1, 3, 5, 7 etc. are moved from load lock 314, to lift 305, to chamber 323, to lift 307, to chamber 321, to chamber 326 and then to load lock 314. Wafers 2, 4, 6, 8 etc. are moved from load lock 316, to lift 307, to chamber 324, to chamber 322, to chamber 325, to lift 305, and then back to load lock 316. The distance the robot travels between consecutive moves is reduced in this sequence.

Automated processing system 200 can also be utilized to conduct processing operations in a dual serial mode. In a dual serial mode, chambers 323 and 324 are the same type of chamber, chambers 322 and 325 are the same type of chamber and chambers 321 and 326 are the same type of chamber. In a representative processing sequence, such as, for example, a metallization process sequence where substrates are pre-cleaned, then have a barrier layer deposited and then have a metal layer deposited, chambers 323 and 324 are pre-clean chambers; chambers 322 and 325 are chambers configured to deposit a suitable seed layer or barrier layer for the desired metal layer; and chambers 321 and 326 are chambers configured to deposit the desired metal layer. When the desired metal layer is, for example, copper, then chambers 322 and 325 are configured to deposit suitable barrier layer or seed layer of, for example, tantalum oxide or tantalum nitride.

In a dual serial process sequence, one representative movement sequence of a substrate through the system is from single substrate load lock 314 to chamber 323 via robot 311, lift 305 and robot 313; from chamber 323 to chamber 322 via robot 313; from chamber 322 to chamber 321 via robot 313, lift 305 and robot 311; from chamber 321 to single substrate load lock 314. Anotner representative movement sequence of a substrate through the system is from single substrate load lock 316 to chamber 324 via robot 311, lift 307 and robot 313; from chamber 324 to chamber 325 via robot 313; from chamber 325 to chamber 326 via robot 313, lift 307 and robot 311; from chamber 326 to single substrate load lock 316. Unlike the parallel processing sequence described above where a pair of substrates are processed nearly simultaneously, substrates in a dual serial processing sequence proceed along two separate serial processing paths through which utilize and share the transfer volume 299.

The dual serial processing sequence will now be described with regard to a copper deposition sequence. For example, chambers 323 and 324 are pre-clean chambers such as the Reactive Pre-Clean II Chamber available from Applied Materials, Inc. of Santa Clara, California; chambers 322 and 325 are IMP PVD Chambers configured to deposit tantalum or tantalum nitride, also available from Applied Materials, Inc. of Santa Clara, California and chambers 321 and 326 are chambers configured to deposit copper such as the IMP VECTRA PVD Cu Chamber available from Applied Materials, Inc. of Santa Clara, California.

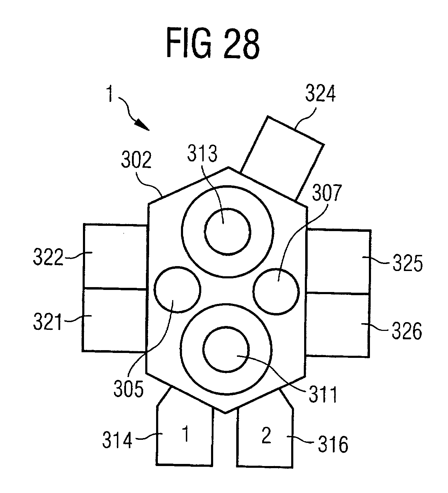

Figures 28-63 represent various representative processing stages of a processing system configured and operated in a manner to optimize substrate throughput. The processing system illustrated is similar to the embodiment shown in Figure 4A and reference can be made thereto. As illustrated in Figures 28-63, the processing system 200 includes five processing chambers 321-326; two load locks 314, 316 each of which are attached to a transfer chamber 302. Transfer chamber 302 includes transfer robots 311, 313 and lifts 305, 307. The processing system illustrated in Figures 28-63 can be configured for a liner barrier processing sequence, for example, in which chamber 324 is a chamber configured for titanium deposition, chambers 321 and 322 are chambers configured for substrate pre-clean operations and chambers 325 and 326 are chambers configured for titanium nitride deposition.

Substrates are loaded into either of the single substrate load locks 314, 316 by atmospheric robot 206 (shown in Figure 4A). The substrates are degassed according to an appropriate degas recipe while the single substrate load lock is evacuated to an appropriate transfer pressure. Next, the substrate is transferred by robot 311 into either pre-clean chamber 322, 321 where an appropriate pre-clean recipe is conducted. Next, the substrate is transferred into chamber 324 where a layer of titanium is deposited. Next, the substrate is transferred into either of chambers 325 or 326 were a layer of titanium nitride is deposited. Finally, the substrate is transferred into either of the single substrate load locks 314, 316 for cool down and subsequent transfer via atmospheric robot 206 into the desired storage cassette 220. Representative process sequence times are, for example, about 30 seconds for a degas operation; about 45 seconds for a cleaning operation; about 25 seconds for a titanium deposition operation; about 45 seconds for a titanium nitride deposition operation and about 10 seconds for a cool down operation. Exact process times for each of the above operations may vary depending on the application. It is to be appreciated that the number and type of process chambers provided on a processing system 200 are selected based on throughput and transfer considerations as well as process operation times for each of the respective chambers.

Referring to Figures 28-52, the illustrative process stages 1-25 can be better appreciated. Each of the process stages 1-25 represents the above-mentioned transfer sequence for a series of wafers numbered 1 through 12 in the figures. The process stages 1 through 18 are referred to as transient process stages and represent a process sequence used to initially fill the system with substrates. A full system refers to a process stage in which each process chamber 321-326 contains a substrate, each transfer robot 311, 313 has a substrate positioned on a blade and a substrate is positioned on either of lifts 305, 307. Once a system is full, the steady state process stages (*e.g.,* the six process states 19 through 24 of Figure 28) are repeated as substrates continuously cycle through the system according to the above described process sequence. It is to be appreciated that a processing system 200 is configurable to provide numerous other processing sequences and chamber configurations.

Process stage 25, like process stage 19, is the first of another set of six steady state process stages illustrated in process states 19-24. System operation during steady state processing stages provides the additional advantage of conducting wafer swaps as wafers are sequenced through the processing system. Wafer swap refers to a wafer movement sequence performed by a two bladed robot where the robot (*e.g.,* transfer robot 311, 313 or atmospheric robot 206) carrying one substrate (*i.e.,* the robot has an empty blade) picks up a substrate with its empty blade and then places the substrate it was carrying into the position from which the substrate was just removed. For example, a substrate swap occurs between process stages 9 and 10 and represents the movement of wafer 1 from a blade on transfer robot 313 to lift 305 and the movement of wafer 5 from lift 305 to the other blade of transfer robot 313. To continue the illustration with wafer 5, robot 313 conducts another wafer swap between process stages 10 and 11 where wafer 3 is removed from chamber 322 with the empty blade of robot 313 (*i.e.,* the robot blade not containing wafer 5) and wafer 5 is subsequently placed into chamber 322.

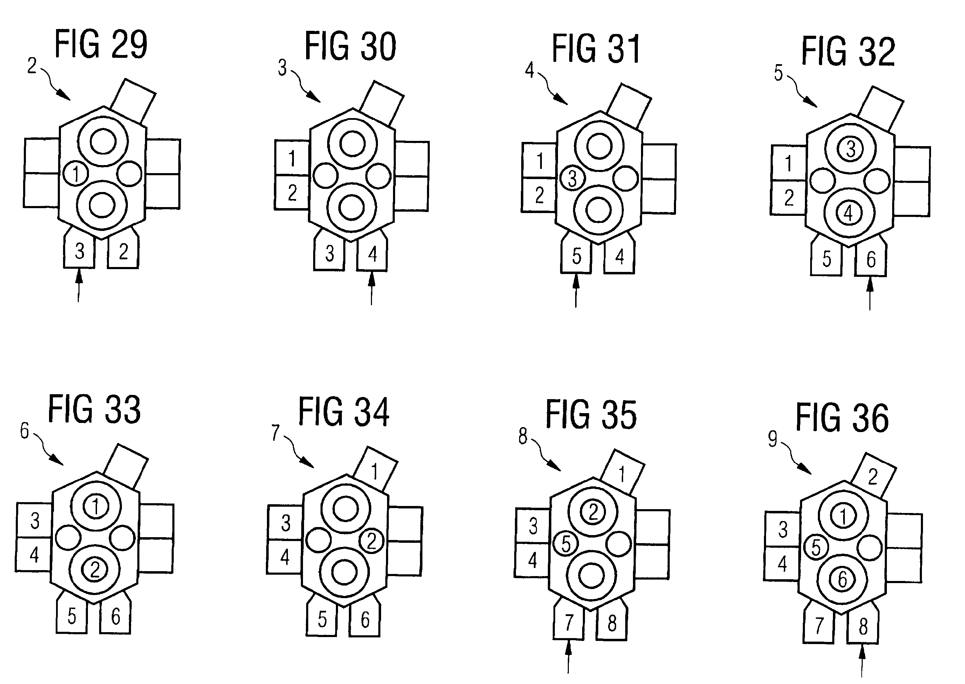

Process stage 1 (Figure 28) illustrates the positioning of wafers 1 and 2 into load locks 314, 316, respectively. Wafers 1 and 2 are degassed according to the desired degas recipe as the load locks 314, 316 are pumped down to a suitable transfer pressure. Process stage 2 (Figure 29) illustrates the transfer of wafer 1 from load lock 314 onto lift 305. Load lock 314 is vented to atmosphere, wafer 3 is then loaded, and degassed as load lock 314 is again evacuated to transfer pressure. Process stage 3 (Figure 30) illustrates the transfer of wafers 1 and 2 into chambers 322 and 321, respectively, where wafers 1 and 2 are processed according to the desired cleaning recipe. Load lock 316 is vented to atmosphere. Wafer 4 is loaded and degassed as load lock 316 is pumped down to transfer pressure. Process stage 4 (Figure 31) illustrates the movement of wafer 3 from load lock 314 onto lift 305, and the venting of load lock 314, loading, and degassing of substrate 5 while load lock 314 is pumped to transfer pressure. Process stage 5 (Figure 32) illustrates the movement of wafer 3 onto a blade of transfer robot 313 and the movement of wafer 4 onto a blade of transfer robot 311. Process stage 5 also illustrates loading substrate 6 into load lock 316 for subsequent degas and evacuation to transfer pressure.

Process stage 6 (Figure 33) illustrates simultaneous wafer swaps conducted by robots 313 and 311. Robot 313 swaps wafer 1 with wafer 3 while robot 311 swaps wafer 2 with wafer 4. Wafers 3 and 4 are now cleaned according to the desired cleaning recipe conducted in chambers 321, 322. Process stage 7 (Figure 34) illustrates the movement of wafer 1 into chamber 324 where the desired titanium deposition process is conducted. Also shown is the movement of wafer 2 from a blade on robot 311 to a position on lift 307. Process stage 8 (Figure 35) illustrates the movement of wafer 2 onto a blade of robot 313 and a movement of wafer 5 from load lock 314 onto lift 305. Also shown is the movement of wafer 7 into load lock 314. It is to be appreciated that as wafers are loaded into either of the load locks 314 or 316, the wafers are degassed according to the desired degas recipe and the associated load lock is evacuated to an appropriate transfer pressure to facilitate the movement of the wafer from the single substrate load lock onto a blade of transfer robot 311. After the wafer is transferred from the load lock onto a blade of transfer robot 311, the load lock is vented to atmospheric pressure in order to receive another wafer from atmospheric robot 206. In addition, later process states such as, for example, process state 20 and process state 22, the load locks 314 and 316 not only vent to atmosphere but are also used to conduct a wafer cool down operation as the wafer exits the transfer chamber 302 (*e.g.*, wafer 1 is being cooled down at process state 20 and wafer 2 is being cooled down during process state 22.)

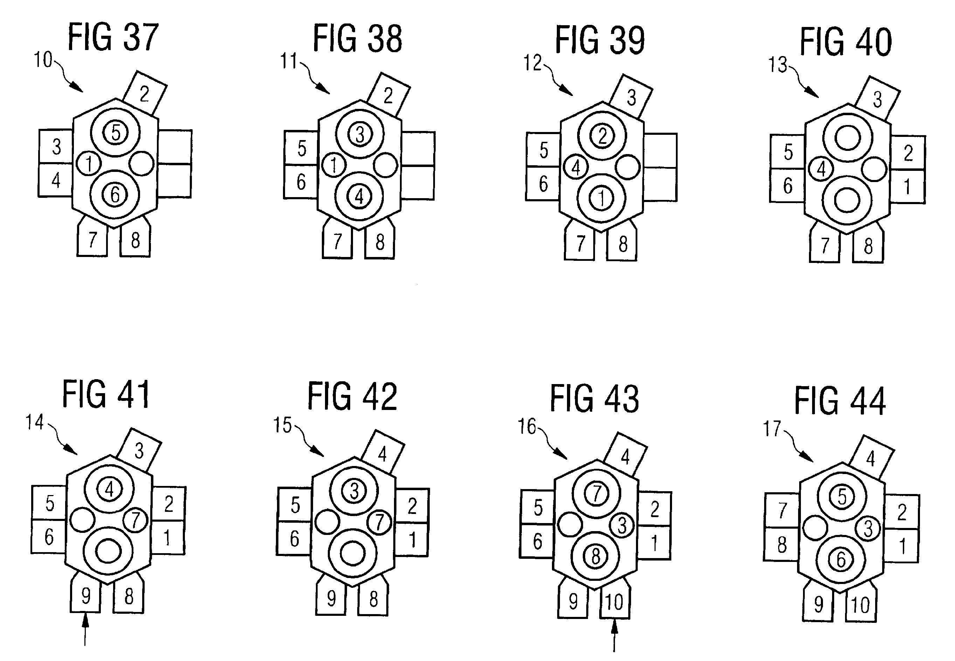

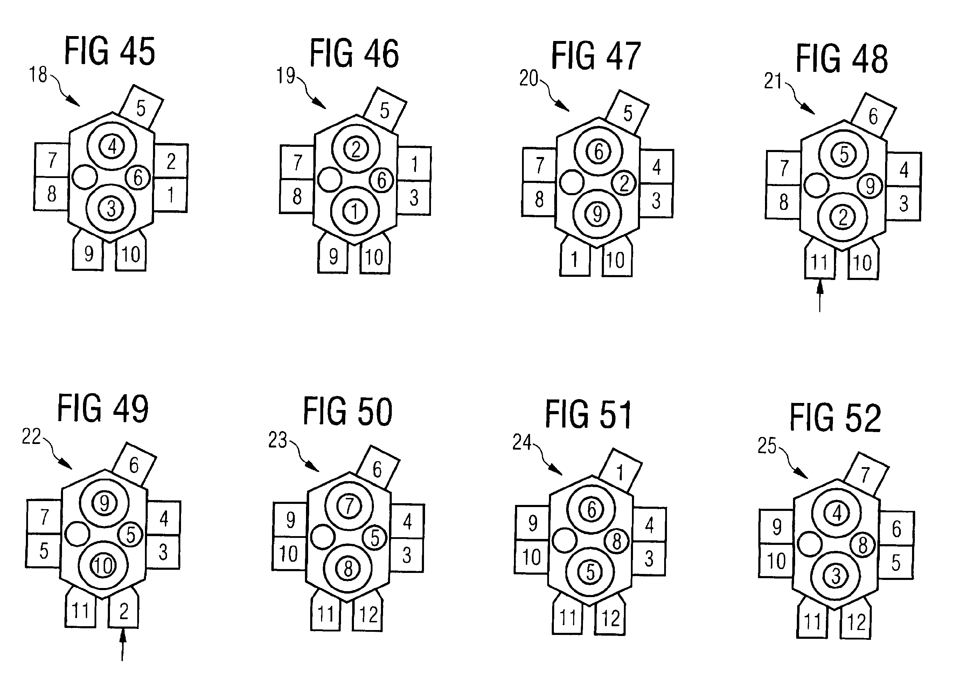

At process stage 9 (Figure 36), robot 313 conducts a wafer swap between wafers 1 and 2. Wafer 6 is transferred onto a blade of robot 313 and wafer 8 is loaded into load lock 316. At process stage 10 (Figure 37), robot 313 conducts a swap with wafers 1 and 5. At process stage 11 (Figure 38) robots 313 and 311 conduct simultaneous swaps. Robot 313 swaps wafers 5 and 3, while robot 311 swaps wafers 4 and 6. At process stage 12 (Figure 39), robot 313 swaps wafers 2 and 3 while robot 311 swaps wafers 1 and 4. At process stage 13 (Figure 40), robots 311 and 313 simultaneously load wafers 1 and 2 into chambers 325 and 326. Wafers 1 and 2 are then processed according to the desired titanium nitride deposition process. At process stage 14 (Figure 41), wafer 4 is moved onto a blade of robot 313 and wafer 7 is moved to lift 307. Additionally, wafer 9 is loaded into load lock 314. Process stage 15 (Figure 42) illustrates the wafer swap conducted by robot 313 for wafers 3 and 4. Process stage 16 (Figure 43) illustrates the wafer swap conducted by robot 313 between wafers 3 and 7; the movement of wafer 8 onto a blade of robot 311; and the loading of wafer 10 into load lock 316. Process stage 17 (Figure 43) illustrates the simultaneous swap conducted by robots 313 and 311 between wafers 5 and 7 and between wafers 6 and 8, respectively. Process stage 18 (Figure 45) illustrates the simultaneous wafer swaps conducted by robot 313 between wafers 4 and 5, and by robot 311 between wafers 3 and 6. Process stage 19 (Figure 46) illustrates the simultaneous wafer swap conducted by robots 313 and 311 between wafers 2 and 4 and between wafers 1 and 3, respectively. Process stage 20 (Figure 47) illustrates a wafer swap conducted by robot 311 between wafers 1 and 9. Load lock 314 at process stage 20 acts as a cool down chamber for wafer 1. This refers to the movement of wafer 1 onto the water cooled pedestal located within load lock 314. Process stage 20 also illustrates the wafer swap conducted by robot 313 between wafers 2 and 6.

At process stage 21 (Figure 48), wafer 1 has been completely processed and unloaded from load lock 314 by atmospheric robot 206. After unloading wafer 1, atmospheric robot 206 conducts a wafer swap that places wafer 11 into load lock 314. Additionally, robots 313 and 311 conduct wafer swaps between wafers 5 and 6 and between wafers 2 and 9, respectively. At process stage 22 (Figure 49), robot 311 conducts a wafer swap between wafers 2 and 10. Wafer 2 is now cooled down in load lock 316. Robot 313 conducts a wafer swap between wafers 9 and 5. At process stage 23 (Figure 50), atmospheric robot 206 swaps processed wafer 2 with incoming wafer 12. At the same time, robots 313 and 311 conduct wafer swaps between wafers 7 and 9 and between wafers 8 and 10, respectively. At process stage 24 (Figure 51), robots 313 and 311 conduct wafer swaps between wafers 6 and 7 and between wafers 5 and 8, respectively. Process stage 25 (Figure 52) illustrates the simultaneous wafer swaps conducted by robots 313 and 311 between wafers positioned on the robots and the wafers positioned in chambers 325 and 326. It is to be appreciated that this simultaneous wafer swap is similar to the wafer swap described with respect to process state 19 and represents the next series of steady state process states which are repeated as wafers systematically cycle through the processing system according to the above described process sequences. Thus, the wafer transfer sequences illustrated by process states 19 to 24 represent the steady-state processing sequences executed by the processing system 200 as configured and described in Figure 28.

## Claims

1. An apparatus for processing substrates, comprising:
a) a transfer chamber;
b) one or more load lock chambers connected to the transfer chamber;
c) one or more process chambers connected to the transfer chamber;
d) a modular plumbing tray disposed adjacent the transfer chamber and having facility connections for one or more of the process chambers and the load lock chambers; and
e) a chamber tray disposed adjacent the one or more of the process chambers, load lock chambers and transfer chamber, the chamber tray having facility connections connected to one or more facility connections in the plumbing tray.

2. A method of processing a substrate, comprising:
a) introducing a substrate into a load lock chamber from atmospheric pressure;
b) degassing and/or pre-heating the substrate in the load lock chamber;
c) introducing the substrate into a transfer chamber; and
d) processing the substrate in one or more process chambers.

3. The method of claim 2 further comprising:
e) introducing the substrate into the load lock chamber;
f) cooling the substrate in the load lock chamber; and then
g) venting the load lock chamber to atmospheric pressure.

4. An apparatus for distributing facility to devices on a processing system, comprising:
a) an enclosure having at least one facility interface and one or more chamber interfaces; and
b) one or more of a process gas manifold, vacuum manifold, water manifold and a helium manifold disposed in the enclosure connected between the at least one facility interface and the one or more chamber interfaces.

5. An apparatus for distributing facility, comprising:
a) a support frame having one or more of an electronics box, a gas panel, a vacuum line and a controller device disposed thereon.

6. A method of processing substrates, comprising:
a) positioning a pair of substrates on two blades on separate robots in a processing system;
b) moving the substrates in parallel to a pair of first process chambers; and then
c) moving the substrates in parallel to a pair of second process chambers.
